# EUROPEAN PATENT SPECIFICATION

(11) **EP 2 041 641 B1**
(45) Date of publication and mention of the grant of the patent: **16.04.2014**
(21) Application number: 07787653.0
(22) Date of filing: 17.07.2007
(51) Int. Cl.: G06F 3/041, G06F 3/044, G06F 3/045, H03K 17/975

(54) **INPUT DEVICE**
EINGABEEINRICHTUNG
DISPOSITIF DE SAISIE

(30) Priority: 18.07.2006 US 488241; 27.02.2007 US 679535
(43) Date of publication of application: 01.04.2009
(73) Proprietor: IEE International Electronics & Engineering S.A.R.L., 6468 Echternach (LU)
(72) Inventor: SERBAN, Bogdan, 3376 Leudelange (LU); BOYER, Philippe, 57570 Boust (FR); SCHOOS, Aloyse, 8094 Bertrange (LU)
(74) Representative: Office Freylinger
(86) International application number: PCT/EP2007/057387
(87) International publication number: WO 2008/009687

(56) References cited:
- US-A- 4 587 378
- US-A- 4 725 817
- US-A1- 2006 001 655

## Description

### Field of the Invention

This invention relates to input devices and more particularly to input devices including a film-based pressure sensor for human-device interaction.

### Background of the Invention

Input devices are commonly used in conjunction with electronic appliances to feed the latter with various kinds of input, including e.g. control input influencing directly or indirectly the behavior of the appliance, input that is processed by the appliance and/or input that is simply stored.

It is known to construct input devices based upon film-type pressure sensors, whose resistance varies with pressure. Such film-type pressure sensor comprises two carrier films, which are arranged at a certain distance from one another by means of a spacer. The spacer is provided with at least one opening that defines an active zone of the sensor, in which the two carrier films face one another. Inside this active zone, at least two electrodes are arranged on the carrier films, in such a way that electrical contact is established between the electrodes when the two carrier films are pressed together under the action of a compressive force acting on the sensor in the active zone. The pressure acting on the sensor is detected and/or determined as a function of the resistance between the electrodes.

Depending on the application of such a pressure sensor, a layer of semiconducting material may be disposed between the electrodes, so that the sensor shows a gradual pressure sensitive behavior, that is to say its resistance varies gradually or even continuously as a function of the force applied. The layer of semiconducting material may comprise a material whose internal electrical resistance varies as a function of compression or of deformation of the layer or a material whose surface structure confers to the layer a surface resistance that is reduced following an increase in the number of points of contact with a conducting surface of an electrode, against which the layer of semiconducting material is pressed under the action of the compressive force.

WO 2004/049364 relates to an input device comprising several keys arranged in at least two rows. A unidirectional position detector of film-type construction is associated with each row of keys. Each unidirectional position sensor enables the detection of the actuated key along the direction of the unidirectional position detector. The unidirectional position sensors are interconnected in such a way that a control circuit can detect in which row a key has been actuated.

A different kind of sensors is based upon capacitive sensing. US 3,896,425 discloses an electrical proximity detector that senses the changes in the contents of a defined sensitive volume. The detector comprises an antenna that is driven by an oscillator and that emits an electric field into the sensitive volume. A person or an object intruding into the sensitive volume causes a change of the electric field of the antenna, which is detected by the detector. To shape the electric field of the antenna the detector comprises a first shield, driven by the oscillator with a signal of same amplitude and phase as the signal of the antenna, and a second, grounded shield.

Other sensors based on electric field or "capacitive" sensing have been proposed by J. Smith et al. in "Electric Field Sensing for Graphical Interfaces", IEEE Computer Graphics and Applications, Issue May/June 1998, 54-60, as a human-computer interface. The interfaces are based upon an array of electrodes to detect the gestures of a user.

US patent application US 2003/0234769 A1 discloses a touch sensor comprising two conductive layers arranged on respective supporting layers, the supporting layers being arranged at a certain distance by means of a spacer. When the touch sensing device is touched, one of the conductive layers is deflected toward the second conductive layer and the resulting change in capacitance between the two conductive layers is sensed in order to determine the touch location.

Yet another capacitive sensing device is known from US 2006/001655 A1 comprising two conductive layers arranged on respective flexible substrates, the substrates being arranged at a certain distance by means of a spacer. If the sensing device is touched, the two conductive layers are pressed together and enter into contact, thus enabling detection of the presence of touch and the location of touch. The capacitive sensing device further comprises electrode arrangements on the outer side of the top substrate, which enable the detection of the proximity of a finger by detecting a capacitance between the upper conductive layer (on the top substrate) and the electrode arrangements on the outer side of the top substrate or between individual electrode arrangements.

The above-mentioned documents are herewith included herein by reference in their entirety.

### Summary of the Invention

It is an object of the present invention to provide an improved input device.

An input device (e.g. a key for a keyboard or a keypad, a touchpad for steering a cursor on a display, a touch screen, and the like) comprises a film-based pressure sensor including a first carrier film, a second carrier film and a spacer arranged between the first and second carrier films. The pressure sensor further includes an electrode arrangement with at least a first electrode and a second electrode, the electrode arrangement being disposed between the first and second carrier films in such a way that, when compressive force acts on the pressure sensor, the first and second carrier films are brought closer together and a first electric quantity measurable between the first and second electrodes varies with respect to a situation when no compressive force is applied to the pressure sensor. The input device comprises a control circuit, which is connected to the first and second electrodes and configured so as to operate in at least a first mode of operation. The control circuit is configured so as to determine, while in the first mode of operation, the first electrical quantity between the first and second electrodes, which is indicative of a compressive force acting on the pressure sensor. According to the invention, the control circuit is configured so as to operate at least in a second mode of operation, wherein the control circuit determines, while in the second mode of operation, a second electrical quantity indicative of a capacitance of the first electrode.

Those skilled in the art will appreciate that the first mode of operation is associated to the detection of a characteristic of a compressive force acting on the input device, e.g. the amount of force (or pressure) applied, the position of the point of application of such force, and/or the like. The second mode of operation is associated to the detection of the capacitance between the first electrode and the surroundings thereof (at some occasions, we use the phrase "capacitance of the first electrode" for designating more concisely "capacitance of a capacitor formed by the first electrode and its surroundings"). Accordingly, in the second mode of operation, the input device is capable of detecting items inducing a change of the capacitance of the first electrode, such as e.g. a user's finger approaching the input device or touching the input device without exerting sufficient pressure for significantly bringing the first and second carrier films closer together. On may consider the second mode of operation as proximity-sensing mode, while the first mode of operation is rather the "pressure-sensing" mode.

It should be noted that the terms "first" and "second", when used in conjunction with the modes of operation are primarily intended for distinguishing between the modes of operation and that the terms should not be understood as indicating an order of the modes of operation in time. The control circuit may operate in the first mode of operation before or after operating in the second mode of operation. For instance, the control circuit could first operate in the second mode of operation and switch to the first mode of operation only if a person or object approaching the active zone has been detected. The control circuit preferably cyclically switches between the modes of operation, e.g. several times per second. Preferably, however, the control circuit remains in the proximity-sensing mode (second mode) until the proximity of a body having an electric-field-influencing property is detected. Alternatively, the control circuit could remain in the pressure-sensing mode (first mode) until a force or pressure exceeding a predefined threshold has been detected.

According to a first main aspect of the invention, the control circuit is configured so as to determine, while in the first mode of operation, an electrical quantity indicative of resistance between the first and second electrodes. Such quantity indicative of resistance may include, for instance, (amount of) current, voltage and/or resistance itself.

According to a second main aspect of the invention, the control circuit is configured so as to determine, while in the first mode of operation, an electrical quantity indicative of capacitance between the first and second electrodes.

For the purposes of the present, a "quantity indicative of capacitance" can be any physical quantity that is linked to the capacitance by the laws of physics, such as, for instance, charging time of an electrode, oscillation period, oscillation frequency, impedance, characteristics of the loading current flowing in an electrode, such as amplitude, phase, in-phase component, 90°-phase-shifted component, and the like.

A summary description of the invention according to the first main aspect of the invention is now provided.

According to the first main aspect of the invention, the input device is provided with a film-based pressure sensor comprising a first carrier film, a second carrier film and a spacer arranged between the carrier films for keeping them at a distance from one another. The spacer has an opening delimiting an active zone, in which first and second electrodes are arranged in such a way that, in response to a compressive force acting on the active zone, an electrical contact is established between the first and second electrodes. A control circuit able to operate at least in the first and the second mode of operation is configured so as to measure, in the first mode of operation, a quantity indicative of electrical resistance between the first and second electrodes for detecting an amount or a position of a compressive force acting on the active zone and, in the second mode of operation, a quantity indicative of a capacitance for detecting a person or an object approaching thereto.

According to a first embodiment of the first main aspect of the invention the first carrier film has a first electrode applied thereon and the second carrier film has a second electrode applied thereon. The first and second electrodes face each other in the active zone in such a way that, in response to compressive force acting on the pressure sensor at the active zone, the first and second carrier films are pressed together and an electrical contact is established between the first and second electrodes. The control circuit is configured so as to measure, in the first mode of operation, a quantity indicative of electrical resistance between the first and second electrodes for detecting an amount of compressive force acting on the active zone and, in the second mode of operation, a quantity indicative of the capacitance of a capacitor formed by the first electrode and its surroundings, for detecting a person or an object approaching thereto. The surroundings of the first electrode may for instance comprise a part of a user's body, such as their hand or finger. The quantity indicative of capacitance can be any physical quantity that is linked to the capacitance by the laws of physics, such as, for instance, amplitude of a current, amplitude of a voltage or impedance. For instance, the amount of current that flows into the first electrode for a given voltage applied to the latter depends on and is therefore indicative of the capacitance of the first electrode.

The input device according to the first embodiment of the first main aspect of the invention preferably comprises a first module for measuring the quantity indicative of electrical resistance, dedicated to the first mode of operation, and a second module for measuring the quantity indicative of a capacitance of the first electrode, dedicated to the second mode of operation.

The first module can, for instance, comprise a current source operationally connected, in the first mode of operation, to the first and second electrodes so as to create a current through the first and second electrodes if an electrical contact is established between the first and second electrodes, and a voltage measurement circuit operationally connected, in the first mode of operation, to the first and second electrodes for measuring a voltage between them, the voltage being indicative of electrical resistance between the first and second electrodes. Alternatively or additionally, the first module can comprise a voltage source operationally connected, in the first mode of operation, to the first and second electrodes for creating a voltage between them and a current measurement circuit operationally connected, in the first mode of operation, for measuring a current flowing through the first and second electrodes, the current being in this case indicative of electrical resistance between the first and second electrodes.

The second module can, for instance, include an AC voltage source operationally connected, in the second mode of operation, at least to the first electrode for applying an oscillating voltage to the first electrode and a current measurement circuit operationally connected, in the second mode of operation, for measuring an electrical current flowing into the first electrode, the electrical current flowing into the first electrode being indicative of the capacitance of the first electrode. Preferably, the AC voltage source is operationally connected, in the second mode of operation, to the first and second electrodes so as to apply voltages of substantially same phase and amplitude to the first and second electrodes. In this case, the potential difference between the first and the second electrodes remains close to zero, so that the second electrode shields the first electrode.

The input device according to the first embodiment of the first main aspect of the invention advantageously comprises a switching unit switching the control circuit between at least the first and second modes of operation.

It will be appreciated that the first and/or the second electrode may comprise a pressure sensitive layer, e.g. a semiconducting layer arranged in facing relationship with the respective other one of the first and second electrodes in the active zone. The pressure sensitive layer may comprise a material whose internal electrical resistance varies as a function of compression or of deformation or a material whose surface structure confers to the layer a surface resistance that is reduced following an increase in the number of points of contact with a conducting surface of an electrode, against which the layer of semiconducting material is pressed under the action of a compressive force.

Preferably, the control circuit is configured so as to output a first output signal responsive to the quantity indicative of electrical resistance and a second output signal responsive to the quantity indicative of a capacitance of the first electrode. The control circuit may comprise, for instance, a first and a second output and be configured so as to output the first output signal at the first output and the second output signal at the second output.

The first and second electrodes are usually formed integrally but according to a variant of the first main aspect of the invention, the first electrode is subdivided into at least two electrode portions. In this case, the at least two electrode portions may be electrically separated at least in the second mode of operation so that the quantity indicative of a capacitance of the first electrode can be determined separately for each one of the at least two electrode portions.

As will be appreciated, a method for operating an input device according to the first embodiment of the first main aspect of the invention comprises the measuring of a quantity indicative of electrical resistance between the first and second electrodes for detecting an amount of compressive force acting on the active zone and the measuring of a quantity indicative of a capacitance of the first electrode for detecting a person or an object approaching thereto. Preferably, the measuring of a quantity indicative of a capacitance of the first electrode includes applying an oscillating voltage to the first electrodes and measuring an electrical current flowing into the first electrode in response to the applied oscillating voltage. Most preferably, the measuring a quantity indicative of a capacitance of the first electrodes includes applying an oscillating voltage to the second electrode, the oscillating voltage applied to the second electrode having substantially same phase and amplitude as the oscillating voltage applied to the first electrode.

A second embodiment of the first main aspect of the invention concerns an input device with a film-based pressure sensor of slightly different configuration. According to the second embodiment of the first main aspect of the invention, the first carrier film has a first electrode and a second electrode applied thereon; the second carrier film has a third electrode applied thereon. The first and second electrodes face the third electrode in the active zone in such a way that, in response to a compressive force acting on the active zone, the first and second carrier films are pressed together and an electrical contact is established between the first and second electrodes via the third electrode. This input device further comprises a control circuit able to operate in at least a first and a second mode of operation, the control circuit being configured so as to measure, in the first mode of operation, a quantity indicative of electrical resistance between the first and second electrodes for detecting an amount of compressive force acting on the active zone and, in the second mode of operation, a quantity indicative of a capacitance of at least one of the first, second and third electrodes for detecting a person or an object approaching thereto. The at least one of the first, second and third electrodes preferably designates, for instance, the first electrode, the first and second electrodes, or the third electrode.

An input device according the second embodiment of the first main aspect of the invention may also comprise a first module for measuring the quantity indicative of electrical resistance, dedicated to the first mode of operation, and a second module for measuring the quantity indicative of a capacitance dedicated to the second mode of operation.

The first module may comprise, for instance a current source operationally connected, in the first mode of operation, to the first and second electrodes so as to create a current through the first and second electrodes if an electrical contact is established between the first and second electrodes via the third electrode, and a voltage measurement circuit operationally connected, in the first mode of operation, to the first and second electrodes for measuring a voltage between them, the voltage being indicative of electrical resistance between the first and second electrodes. Alternatively or additionally, the first module may comprise a voltage source operationally connected, in the first mode of operation, at the first and second electrodes for creating a voltage between them and a current measurement circuit operationally connected, in the first mode of operation, for measuring a current flowing through the first and second electrodes, the current being indicative of electrical resistance between the first and second electrodes.

The second module preferably includes an AC voltage source operationally connected, in the second mode of operation, at least to the at least one of the first, second and third electrodes for applying an oscillating voltage to the at least one of the first, second and third electrodes and a current measurement circuit operationally connected, in the second mode of operation, for measuring an electrical current flowing into the at least one of the first, second and third electrodes, the electrical current flowing into the at least one of the first, second and third electrodes being indicative of a capacitance of the at least one of the first, second and third electrodes. Most preferably, this AC voltage source is operationally connected to the first, second and third electrodes so as to apply voltages of substantially same phase and amplitude to the first, second and third electrodes, in the second mode of operation.

The input device according to the second embodiment of the first main aspect of the invention may further comprise a switching unit switching the control circuit between at least the first and second modes of operation.

Advantageously, at least one of the first, second and third electrodes comprises a pressure sensitive layer arranged in facing relationship with a respective other one or respective other ones of the first, second and third electrodes in the active zone.

The control circuit is preferably configured so as to output a first output signal responsive to the quantity indicative of electrical resistance and a second output signal responsive to the quantity indicative of a capacitance of the at least one of the first, second and third electrodes. Most preferably, the control circuit comprises at least a first and a second output, the control circuit being configured so as to output the first output signal at the first output and the second output signal at the second output.

As in the input device according to the first embodiment of the first main aspect of the invention, the electrodes in the input device according to the second embodiment of the first main aspect of the invention are normally formed integrally. Nevertheless, the at least one of the first, second and third electrodes can be subdivided into at least two electrode portions that are electrically separated at least in the second mode of operation. In this case, the quantity indicative of the capacitance of the at least one of the first, second and third electrodes can be determined separately for each one of the at least two electrode portions.

As will be appreciated, a method for operating an input device according to the second embodiment of the first main aspect of the invention comprises the measuring of the quantity indicative of electrical resistance between the first and second electrodes for detecting an amount of compressive force acting on the active zone and the measuring the quantity indicative of a capacitance of the at least one of the first, second and third electrodes for detecting a person or an object approaching thereto. Preferably, the measuring of a quantity indicative of the capacitance of the at least one of the first, second and third electrodes includes applying an oscillating voltage to the at least one of the first, second and third electrodes and measuring an electrical current flowing into the at least one of the first, second and third electrodes in response to the applied oscillating voltage. Most preferably, the measuring of the quantity indicative of a capacitance of the at least one of the first, second and third electrodes includes applying an oscillating voltage to the other one or the other ones of the at least one of the first, second and third electrodes, the oscillating voltage applied to the other one or other ones of the at least one of the first, second and third electrodes having same phase and amplitude as the oscillating voltage applied to the at least one of the first, second and third electrodes.

According to a third embodiment of the first main aspect of the invention an input device is proposed that comprises a film-based position sensor. The position sensor comprises a first carrier film, a second carrier film and a spacer arranged between the first and second carrier films for keeping the first and second carrier films at a distance from one another, and comprising an opening delimiting an active zone of the position sensor. The first carrier film has a first electrode and a second electrode applied thereon; the second carrier film has a third electrode applied thereon. The first electrode includes a series of resistively connected first conductors. The third electrode faces the first electrode and the second electrode in the active zone in such a way that, in response to a compressive force acting on the active zone, the first and second carrier films are pressed together and an electrical contact is established between one or more of the first conductors and the second electrode via the third electrode. The input device according to the fifth aspect of the invention further comprises a control circuit able to operate in at least a first and a second mode of operation, the control circuit being configured so as to measure, in the first mode of operation, a quantity indicative of a position of resistive coupling between the first electrode and the second electrode for detecting a position of a compressive force acting on the active zone and, in the second mode of operation, a quantity indicative of a position of capacitive coupling between the first electrode and the second electrode for detecting a position of a person or an object approaching to the input device.

In an input device according to the third embodiment of the first main aspect of the invention, the second electrode preferably comprises a series of conductively connected second conductors, the first and second conductors being arranged so as to interdigitate.

To obtain the position of a compressive force or a capacitive coupling in two dimensions, the film-based position sensor may comprise a plurality of active zones, delimited by an opening or openings of the spacer. The first carrier film has a first electrode and a second electrode applied thereon in each one of the active zones and the second carrier film has a third electrode applied thereon in each one of the active zones. Each first electrode includes a series of resistively connected first conductors. Each third electrode faces its respective first and second electrodes in the respective active zone in such a way that, in response to a compressive force acting on an active zone, the first and second carrier films are pressed together and the third electrodes provides an electrical contact between one or more of the first conductors of the respective first electrode and the respective second electrode. The control circuit is in this case able to operate in at least a first and a second mode of operation and configured so as to measure, in the first mode of operation, a quantity indicative of a position in two dimensions of resistive coupling between said first electrode and said second electrode for detecting a position in two dimensions of a compressive force and, in the second mode of operation, a quantity indicative of a position of capacitive coupling between said first electrode and said second electrode for detecting a position of a person or an object approaching to said input device.

Input devices referred to hereinabove include but are not limited to keyboards, keypads, touch screens, touch panels, computer mice, etc. In case of devices with keys, one or several keys may be associated to each active zone of the device. Detecting of the position (in one or in two dimensions) of the compressive force can in this case be considered equivalent to determining which key has been actuated.

Preferably, in the embodiments of the first main aspect of the invention, the spacer is substantially incompressible in the sense that it thickness does not change significantly (i.e. less than by 25 % or more preferably by less than 10 % of the initial thickness) in response to pressure in the range of normal pressure exerted by a human finger or stylus.

As shall be appreciated, the carrier films, the spacer the electrodes, as well as any other layers or components of an input device according to the first main aspect of the invention may be made of transparent, semi-transparent or translucent material, in such a way that the input device may be back-illuminated and/or positioned on top of a display screen.

Turning now to the second main aspect of invention, an input device comprises a capacitive proximity and pressure sensor, which includes a first carrier layer, a second carrier layer and a spacer arranged between the first and second carrier layers, the first carrier layer having a first electrode applied thereon, the second carrier layer having a second electrode applied thereon, the first and second electrodes being arranged opposite one another with respect to the spacer in such a way that, in response to a compressive force acting on the pressure sensor, the first and second electrodes are brought closer together. The input device further comprises a control circuit configured so as to operate in at least two modes of operation, including a first and a second mode of operation. The control circuit determines, while in the second mode of operation, a quantity indicative of a capacitance between the first electrode and the surroundings thereof, e.g. a grounded surface, and, while in the first mode of operation, a quantity indicative of a capacitance between the first electrode and the second electrode. Those skilled will appreciate that the capacitance between the first electrode and ground is itself indicative of the proximity of a part of a user's body (e.g. their finger) to the first electrode. As mentioned hereinbefore, the second mode of operation may therefore be considered as the "proximity-sensing" mode. On the other hand, the capacitance between the first and the second electrode is indicative of the distance between these electrodes. Since a given distance corresponds to a certain amount of pressure or magnitude of force, the first mode of operation is considered as the "pressure-sensing" (or "force-sensing") mode.

According to a second embodiment of the second main aspect of the invention, the input device comprises a capacitive proximity and pressure sensor, which includes a first carrier layer, a second carrier layer and a spacer arranged between the first and second carrier layers. The first carrier layer has a plurality of first electrodes applied thereon and the second carrier layer has a plurality of second electrodes applied thereon, each one of the plurality of first electrodes being arranged opposite a respective one of the plurality of second electrodes with respect to the spacer in such a way that, in response to a compressive force acting on the pressure sensor, respectively opposite ones of the first and second electrodes are brought closer together. The input device according to the second embodiment of the second main aspect of the invention further comprises a control circuit configured so as to operate in at least two modes of operation, including a first and a second mode of operation. The control circuit determines, while in the first (proximity-sensing) mode of operation, a quantity indicative of a capacitance between individual ones (single ones or groups) of the plurality of first electrodes and ground and, while in the second (pressure-sensing) mode of operation, a quantity indicative of a capacitance between individual ones of the plurality of first electrodes and the respectively opposite ones of the plurality of second electrodes.

According to a third embodiment of the second main aspect of the invention, the input device comprises a capacitive proximity and pressure sensor, which includes a first carrier layer, a second carrier layer and a spacer arranged between the first and second carrier layers. The first carrier layer has a plurality of first electrodes applied thereon, the first electrodes being elongated in a first direction, and the second carrier layer has a plurality of second electrodes applied thereon, the second electrodes being elongated in a second direction. The first electrodes are arranged opposite the plurality of second electrodes with respect to the spacer. According to the present embodiment, the first elongated electrodes extend transversally to the second elongated electrodes (e.g. the first and second directions form an angle of approximately 90° there between, preferably an angle in the range from 60 to 90°) in such a way that, in response to a compressive force acting locally on the pressure sensor, opposite ones of the first and second electrodes are brought closer together at the location where the compressive force acts on the pressure sensor. The input device also comprises a control circuit, which determines, while in a second mode of operation, a quantity indicative of capacitance between individual ones of the plurality of first electrodes and ground and, while in a first mode of operation, a quantity indicative of a capacitance between individual ones of the plurality of first electrodes and individual ones of the plurality of second electrodes.

According to a fourth embodiment of the second main aspect of the invention, the input device comprises a capacitive proximity and pressure sensor, which includes a first carrier layer, a second carrier layer and a spacer arranged between the first and second carrier layers for keeping the first and second carrier layers apart from one another. The first carrier layer has a plurality of first electrodes applied thereon, the second carrier layer has a second electrode applied thereon, the plurality of first electrodes being arranged opposite the second electrode with respect to the spacer in such a way that, in response to a compressive force acting locally on the pressure sensor, individual ones of the first electrodes are brought closer to the second electrode at the location where the compressive force acts on the pressure sensor. The input device according to the fourth embodiment of the second main aspect of the invention comprises a control circuit, which determines, while in a second mode of operation, a quantity indicative of capacitance between individual ones of the first electrodes and ground and, while in a first mode of operation, a quantity indicative of a capacitance between the second electrode and individual ones of the first electrodes.

According to a variant of the second main aspect of the invention, the spacer is electrically insulating and compressible. According to this variant, opposite ones of the first and second electrodes are brought closer together when the spacer is compressed in response to a compressive force acting on the pressure sensor. Preferably, however, the spacer is substantially incompressible in the sense that it thickness does not change significantly (i.e. less than by 25 % or more preferably by less than 10 % of the initial thickness) in response to pressure in the range of normal pressure exerted by a human finger or stylus.

According to another preferred variant of the second main aspect of the invention, the spacer has one or more openings therein, with respect to which the first electrode or electrodes are arranged opposite the second electrode or electrodes. The first capacitive electrode(s) and/or the second electrode(s) have an insulating layer or insulating pattern arranged thereon in such a way as to prevent a short circuit between the first capacitive electrode(s) and the second electrode(s). The insulating layer or pattern could be separate from the spacer or part of it (in the latter case the opening would rather be considered as a recess than as a through-hole). The spacer may be compressible or incompressible. In the latter case, the first and second electrodes are brought closer together when one or both of the carrier layers bend into the opening(s) of the spacer under the action of the compressive force.

If the spacer has a plurality of openings therein, if the first carrier layer has a plurality of first electrodes applied thereon and if the second carrier layer has a plurality of second electrodes applied thereon, each one of the plurality of first electrodes is preferably arranged opposite a respective one of the plurality of second electrodes with respect to a respective one of the plurality of openings. In this case, when a compressive force acts on the pressure sensor, respectively opposite ones of the first and second electrodes are brought closer together.

The input device according to the second main aspect of the invention may comprise a first module for measuring the quantity indicative of capacitance between the first and second electrodes, dedicated to the first mode of operation, and a second module for measuring the quantity indicative of a capacitance between the first electrode and ground, dedicated to the second mode of operation. These modules can be separate or comprise shared i.e. common components.

Those skilled will appreciate that various options exist for determining a quantity indicative of capacitance between the first electrode(s) and ground. For instance, the control circuit could determine, while in the second mode of operation,
a. an amount of electric charge accumulated on (individual ones of) the first electrode(s) in response to applying a defined voltage to this (these) first electrode(s); or
b. an amplitude and/or a phase of a loading current flowing in (individual ones of) the first electrode(s) in response to applying an oscillating voltage to this (these) first electrode(s); or
c. an in-phase component and/or a 90°-phase-offset component of a loading current flowing in (individual ones of) the first electrode(s) in response to applying an oscillating voltage to this (these) first electrode(s); or
d. a charge time and/or a discharge time of (individual ones of) the first electrode(s).

Similarly, various options exist for determining a quantity indicative of capacitance between (individual ones of) the first electrode(s) and (individual ones of) the second electrode(s). For instance, the control circuit could determine, while in the first mode of operation,
a. an amount of electric charge accumulated on (individual ones of) the first electrode(s) and/or (on individual ones of) the second electrode(s) in response to an applying a defined voltage to the respectively opposite electrode(s);
b. an amount of electric charge accumulated on (individual ones of) the first electrode(s) and/or (on individual ones of) the second electrode(s) in response to an applying a defined voltage to this (these) electrode(s);
c. an amplitude and/or a phase of a loading current flowing (in individual ones of) the first electrode(s) in response to applying an oscillating voltage to this (these) first electrode(s);
d. an amplitude and/or a phase of a loading current flowing (in individual ones of) the second electrode(s) in response to applying an oscillating voltage to this (these) second electrode(s);
e. an amplitude and/or a phase of a loading current flowing (in individual ones of) the first electrode(s) in response to applying an oscillating voltage to the respectively opposite one(s) (of the) second electrode(s);
f. an amplitude and/or a phase of a loading current flowing (in individual ones of) the second electrode(s) in response to applying an oscillating voltage to the respectively opposite one(s) (of the) first electrode(s);
g. an in-phase component and/or a 90°-phase-offset component of a loading current flowing (in individual ones of) the first electrode(s) in response to applying an oscillating voltage to this (these) first electrode(s);
h. an in-phase component and/or a 90°-phase-offset component of a loading current flowing (in individual ones of) the second electrode(s) in response to applying an oscillating voltage to this (these) second electrode(s);
i. an in-phase component and/or a 90°-phase-offset component of a coupling current flowing (in individual ones of) the first electrode(s) in response, to applying an oscillating voltage to the respectively opposite one(s) (of the) second electrode(s);
j. an in-phase component and/or a 90°-phase-offset component of a coupling current flowing (in individual ones of) the second electrode(s) in response to applying an oscillating voltage to the respectively opposite one(s) (of the) first electrode(s);
k. a charge and/or a discharge time of the first and/or the second electrode.

While in the second mode of operation, the control circuit preferably applies a first voltage to the first electrode(s) and a second voltage to the second electrode(s), the first and second voltages having same amplitude and phase. As will be appreciated, this substantially cancels the electric field between the first and second electrodes so that the first electrode(s) becomes (become) substantially insensitive in direction of the second electrode(s).

Input devices referred to hereinabove include but are not limited to keyboards, keypads, touch screens, touch panels, computer mice, etc. In case of devices with keys, one or several keys may be associated to each active zone of the device. Detecting of the position (in one or in two dimensions) of the compressive force can in this case be considered as determining which key has been actuated.

As shall be appreciated, the carrier films, the spacer the electrodes, as well as any other layers or components of an input device according to the second main aspect of the invention may be made of transparent, semi-transparent or translucent material, in such a way that the input device may be back-illuminated and/or positioned on top of a display screen.

Regarding both main aspects of the invention, the first carrier layer, the spacer and the second carrier layer are preferably laminated together.

### Brief Description of the Drawings

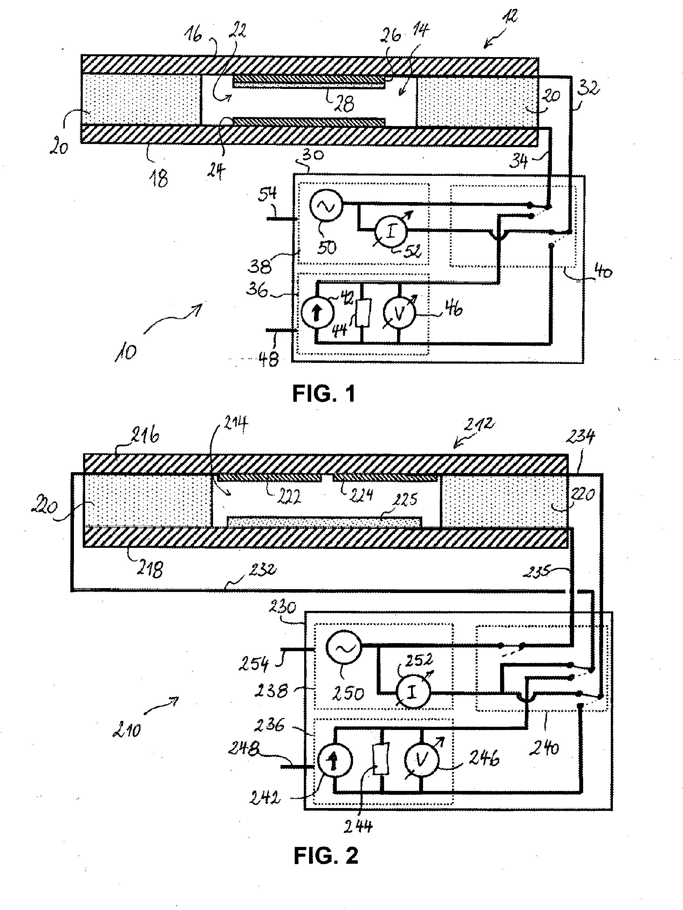

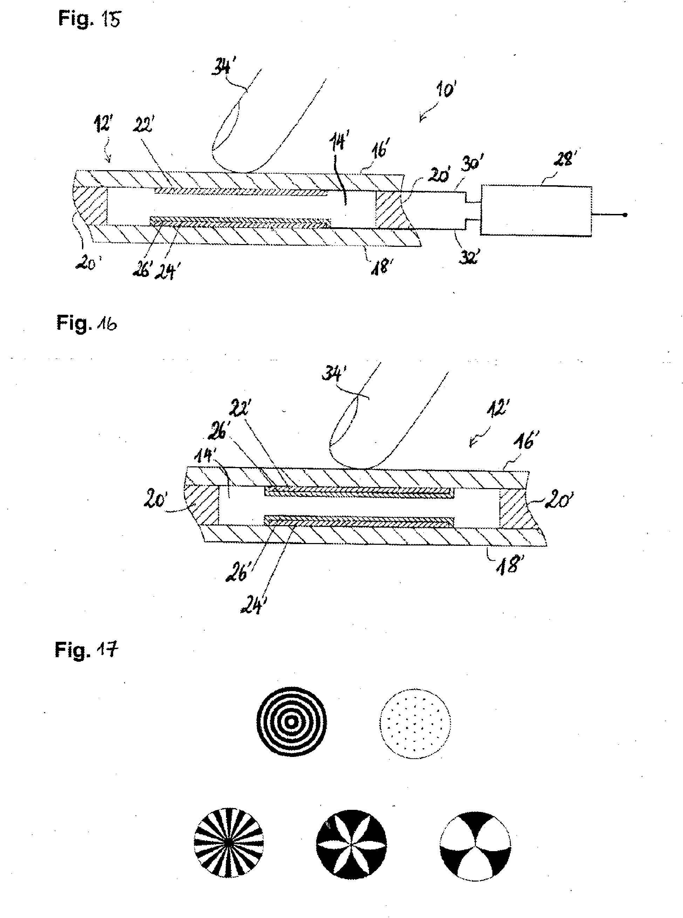

Further details and advantages of the present invention will be apparent from the following detailed description of several not limiting embodiments with reference to the accompanying drawings, wherein Figs. 1 to 14 relate to the first main aspect of the invention and Figs.15 to 25b relate to the second main aspect of the invention:
Fig. 1 is a schematic representation of an input device according to the first embodiment of the first main aspect of the invention;
Fig. 2 is a schematic representation of an input device according to the second embodiment of the first main aspect of the invention;
Fig. 3 is an equivalent circuit diagram of a module for measuring a quantity indicative of capacitance;
Fig. 4 is an illustration of the capacitances intervening during the measurement of a quantity indicative of capacitance;
Fig. 5 is an illustration of an example of a possible layout of the first and second electrodes in the device of Fig. 2;
Fig. 6 an illustration of another example of a possible layout of the first and second electrodes in the device of Fig. 2;
Fig. 7 is a schematic cross sectional view of a pressure sensor that can be used in a device according to the third embodiment of the first main aspect of the invention; ,
Fig. 8 is a schematic illustration of an input device that uses the pressure sensor of Fig. 7;
Fig. 9 is an equivalent circuit diagram of the device of Fig. 8 during the determination of the position of capacitive coupling.
Figs. 10 and 11 are schematics of a circuit of an input device with a 2D position sensor;
Figs. 12 and 13 are schematics of a circuit of another input device with a 2D position sensor;
Fig. 14 is a schematic illustration of the impedance of the first electrode varying as a function of the distance of an actuating member,
Fig. 15 is a schematic cross sectional view of capacitive pressure and proximity sensor according to a first embodiment;
Fig. 16 is a schematic cross sectional view of an input device according to a second embodiment;
Fig. 17 is an illustration of different examples of electrically insulating patterns;
Figs. 18a and 18b are cross sectional views of a touchpad having keypad functionality;
Figs. 19a and 19b are cross sectional views of an alternative touchpad having keypad functionality;
Figs. 20a and 20b are cross sectional views of yet another example of a touchpad having keypad functionality;
Figs. 21a-21c are illustrations of a touchpad with keypad functionality, in which the keys are arranged along a straight line;
Figs. 22a-22e are illustrations of an input device implemented as a linear slider;
Figs. 23a-23d are illustrations of an input device implemented as a circular slider;
Figs. 24a-24d are illustrations of variants of an alternative embodiment of a touchpad;
Figs. 25a-25b are cross-sectional schematic views of yet another example of an input device.

### Description of Preferred Embodiments

Fig. 1 shows an input device according to the first embodiment of the first main aspect of the invention. The device 10 comprises pressure sensor 12 of film-type construction with an active zone 14. The pressure sensor 12 comprises first and second carrier films 16, 18, made of substantially flexible, electrically insulating material, such as e.g. PET, PEN, PI or the like. A spacer 20 is sandwiched between the first and second carrier films 16, 18, thereby arranging the carrier films the distance corresponding to the spacer thickness from one another. The spacer can also be made of any substantially flexible, electrically insulating material. The spacer is provided with an opening that delimits the active zone 14 of the pressure sensor 10. In the active zone 14, the first carrier foil 16 carries a first electrode 22 on its inward-facing side, while the second carrier foil 18 carries a second electrode 24 on its inward-facing side. The first electrode 22 comprises a conductive layer 26 applied directly on the first carrier foil 16 and a pressure sensitive layer 28 facing towards the second electrode. The second electrode is provided by a conductive layer. The electrodes are preferably printed ones.

The first and second electrodes 22, 24 are connected to a control circuit 30 by leads 32 and 34. The control circuit 30 comprises a first module 36 for measuring a quantity indicative of electrical resistance between the first and second electrodes 22, 24, a second module 38 for measuring a quantity indicative of the capacitance of the first electrode and a switching unit 40 for connecting alternatively the first or the second module to the electrodes 22, 24.

The first module 38 comprises a current source 42 whose terminals can be connected to the first and second electrodes, respectively, through the switching unit 40. A reference resistor 44 and a voltage measurement circuit 46 are connected in parallel to the current source 42. In operation, i.e. in the first operating mode, the current source tries to create a defined current between its terminals. As long as the electrodes 22 and 24 are separated from each other, i.e. when the compressive force acting on the pressure sensor is not sufficient for pressing the carrier films together in the active zone 14, the current can flow only through the reference resistor 44 because of the very high input impedance of the voltage measurement circuit 46. If however, the electrodes 22 and 24 are in contact, the total resistance connected in parallel to the voltage measurement circuit drops so that the voltage necessary to keep the defined current upright drops. In other words, the potential difference measured by the voltage measurement circuit is indicative of the resistance between the first and second electrodes 22, 24. In response to the measurement, the first module outputs a first signal on the first output 48.

The second module 38, dedicated to the "capacitive" measurement, comprises a AC voltage source 50, providing an oscillating signal to both the first and second electrodes 22, 24 through the switching unit 40. A current measurement circuit 52 measures the current flowing into the first electrode. The amount of current that may flow into the first electrode depends on and is therefore indicative of the capacitance of a capacitor formed by the first electrode and its surroundings. The second module outputs a second signal on the second output 54 of the control circuit, depending on the measured current.

Fig. 2 shows an input device according to the second embodiment of the first main aspect of the invention The device 210 comprises pressure sensor 212 of film-type construction with an active zone 214. The pressure sensor 212 comprises first and second carrier films 216, 218, made of substantially flexible, electrically insulating material, such as e.g. PET, PEN, PI or the like. A spacer 220 is sandwiched between the first and second carrier films 216, 218, thereby arranging the carrier films the distance corresponding to the spacer thickness from one another. The spacer can also be made of any substantially flexible, electrically insulating material. The spacer is provided with an opening that delimits the active zone 214 of the pressure sensor 210. In the active zone 14, the first carrier foil 216 carries a first electrode 222 and a second electrode 224 on its inward-facing side, while the second carrier foil 218 carries a third electrode 225 on its inward-facing side. The first and second electrodes 222, 224 are provided by a conductive layer applied directly on the first carrier foil 216. The third electrode 225 comprises a pressure sensitive layer facing towards the first and second electrode 222, 224. The electrodes are preferably printed ones.

The electrodes 222, 224, 225 are connected to a control circuit 230 by leads 232, 234 and 235, respectively. The control circuit 230 comprises a first module 236 for measuring a quantity indicative of electrical resistance between the first and second electrodes 222, 224, a second module 238 for measuring a quantity indicative of the capacitance of the first and second electrodes 222, 224 and a switching unit 240 connecting alternatively the first or the second module to the electrodes 222, 224 and 225.

The first module 238 comprises a current source 242 whose terminals can be connected to the first and second electrodes, respectively, through the switching unit 240. A reference resistor 244 and a voltage measurement circuit 246 are connected in parallel to the current source 242. In operation, i.e. in the first operating mode, the current source 242 tries to create a defined current between its terminals. As long as the compressive force acting on the pressure sensor is not sufficient for pressing the carrier films together in the active zone 214, the current can flow only through the reference resistor 244 because of the very high input impedance of the voltage measurement circuit 246. If however, the carrier films are pressed together, both the first electrode 222 and the second electrode 224 gets into contact with the third electrode 225. As a consequence, the total resistance connected in parallel to the voltage measurement circuit 246 drops, so that the voltage necessary to keep the defined current upright drops as well. In other words, the potential difference measured by the voltage measurement circuit 246 is indicative of the resistance between the first and second electrodes 222, 224. In response to the measurement, the first module 236 outputs a first signal on the first output 248.

The second module 238, dedicated to the "capacitive" measurement, comprises a AC voltage source 250, providing an oscillating signal to electrodes 222, 224 and 225, through the switching unit 240. A current measurement circuit 252 (e.g. a current meter) measures the current flowing into the first and second electrodes 222, 224. The amount of current that may flow into these electrodes depends on and is therefore indicative of the capacitance of a capacitor formed by the first and second electrodes and its surroundings. The second module 238 outputs a second signal on the second output 254 of the control circuit, depending on the measured current.

The input device may be operated alternately in the mode of operation associated to the resistance measurement and in the mode of operation associated to the "capacitance" measurement. Those skilled will understand that the duration of these measurement modes may be equal or different. Furthermore, the frequencies of the different modes of operation may be equal or different. For instance it is possible that the input device is operated in the mode of operation associated to the resistance measurement only half often as in the mode of operation associated to the "capacitance" measurement, or vice versa. There may be other modes of operation of the input device, such as, for instance an error diagnose mode, in which the input device checks for possible short circuits or circuit interruptions.

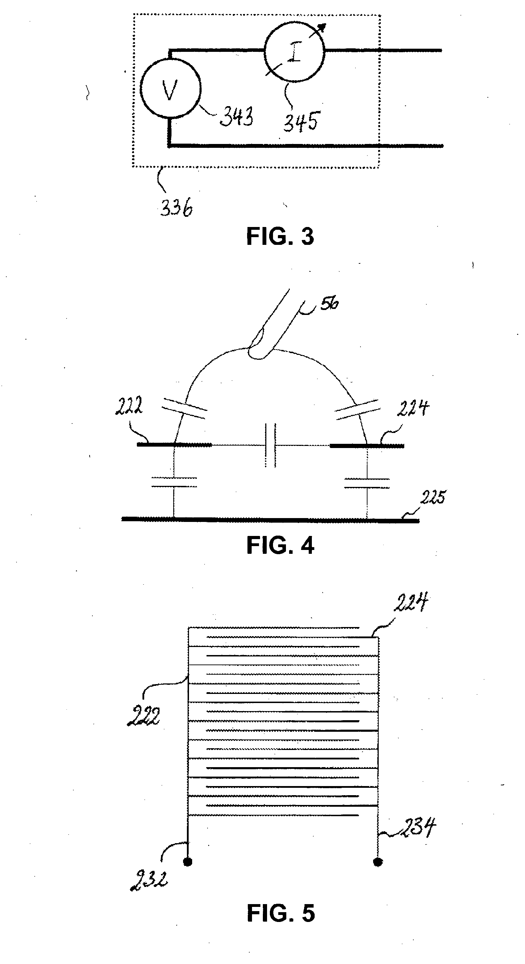

Fig. 3 shows an alternative embodiment of a module capable of measuring a quantity indicative of resistance between the first and second electrodes. The module 336 comprises a voltage source 343 connected in series with a current measurement circuit 345. In the first measurement mode, the voltage source applies a potential difference between the first and second electrodes. If an electrical contact is established between these, either directly or via a third electrode, the resistance between the electrodes decreases and the current measured by the current measurement circuit increases according to Ohm's law. The module 336 could be substituted to module 36 in Fig. 1 and to module 236 in Fig. 2. Those skilled will be aware of other electric circuits that can measure a quantity indicative of resistance.

Fig. 4 schematically shows the capacitances intervening during the "capacitive" measurement in the case of an input device 210 as in Fig. 2. Of the input device 210, only the electrodes 222, 224 and 225 are shown. During the "capacitive" measurement, one measures a quantity indicative of the capacitance formed by the first and second electrodes 222, 224 and their surroundings. As illustrated, a variety of (virtual) capacitors have to be considered. For instance, the first and second electrodes form a capacitor with the third electrode. If a user approaches to the input device with any portion of their body, e.g. their finger 56, the capacitance of the capacitor formed by the first and second electrodes 222, 224 with the surroundings changes, and this change is detected by the input device. It should be noted that if the electrodes 222, 224 and 225 are all driven with a signal of same amplitude and phase, they are remain at substantially the same electric potential during the measurement. Consequently, the capacitances of the capacitors formed by the first and second electrodes, the first and third electrodes and the second and third electrodes remain substantially constant. In particular, the third electrode shields the first and second electrodes from changes in the electric field that occur behind the third electrode, as seen from the first and second electrodes.

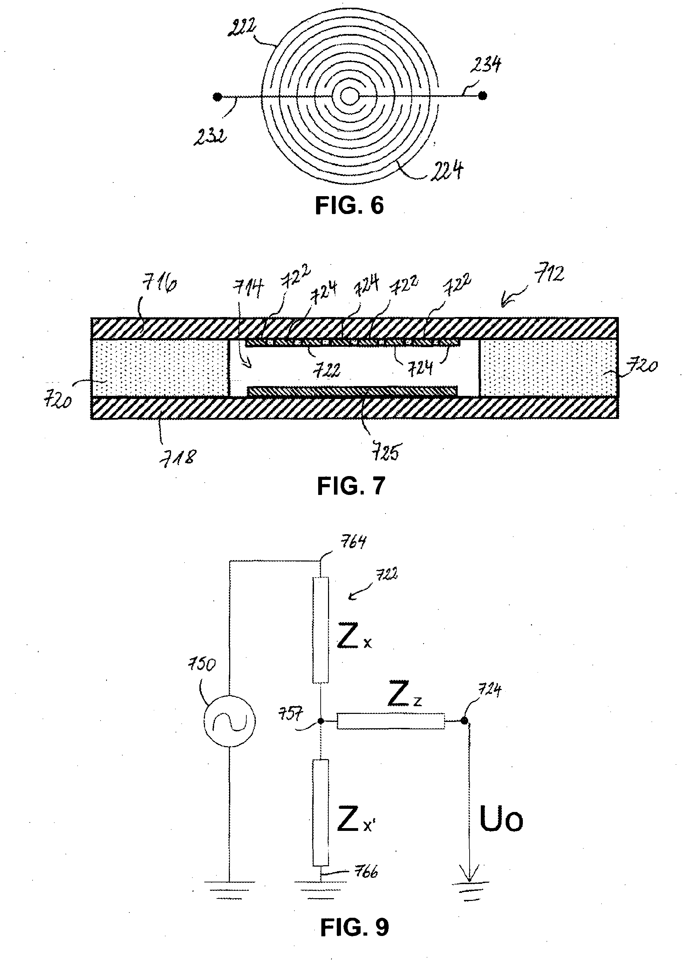

Figs. 5 and 6 show two possible layouts of the first and second electrodes 222 and 224. In Fig. 5, both electrodes comprise a number of conductors with interconnected first ends and free second ends so as to be of substantially comb-like appearance. The conductors are arranged substantially parallel to one another, the conductors of the first electrode interdigitating with the conductors of the second electrode. In the embodiment of Fig. 6, the electrodes comprise a number of concentrically arranged conductive ring portions. Starting at the central point of the arrangement, the conductive ring portions belong alternately to the second and the first electrodes. It shall be noted that several other electrode layouts could be used for putting the present invention into practice.

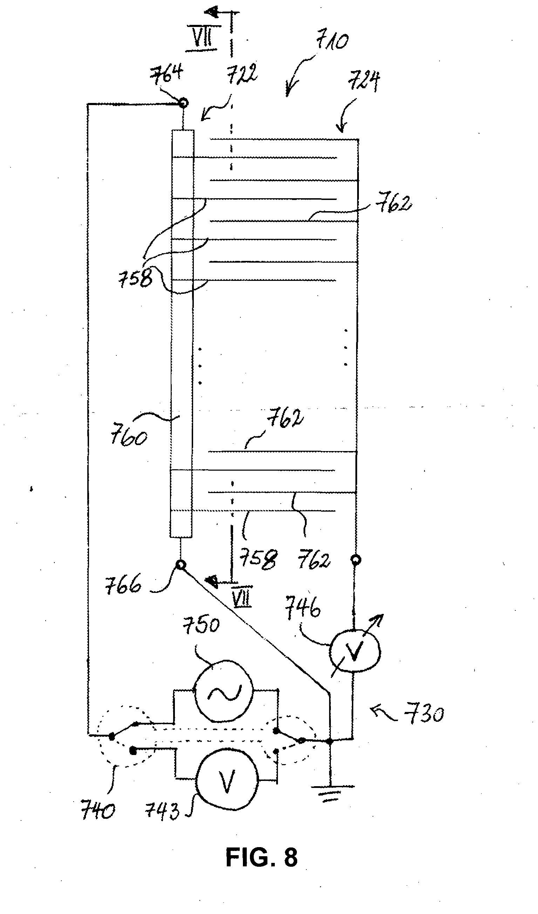

Fig. 7 shows a schematic of a film-based position sensor 712 of an input device according to the third embodiment of the first main aspect of the invention. The position sensor 712 comprises first and second carrier films 716, 718 spaced apart by a spacer 720. The spacer 720 is provided with an opening delimiting an active zone 714 of the position sensor 712. The first carrier film 716 carries a first electrode 722 and a second electrode 724 on its inward-facing surface; the second carrier film 718 carries a third electrode 725 on its inward-facing surface. The third electrode 725 faces the first electrode 722 and the second electrode 724 in the active zone 714. The second and third electrodes are conductive electrodes. A top schematic view of the first and second electrodes is given in Fig. 8. Both the first and second electrodes 722, 724 are essentially comb-shaped. The first electrode 722 includes a series of resistively connected first conductors 758 arranged substantially parallel one to another. The resistive connection of the first conductors 758 is provided by a resistive strip 760. The second electrode 724 includes a series of conductively connected conductors 762, that interdigitate with the conductors of the first electrode 722. The third electrode 725 is not connected.

If a compressive force acts locally onto the position sensor, the first and second carrier films 716, 716 are pressed together and an electrical contact is established between one or more of the conductors 758 and the second electrode 724 via the third electrode 725. By measuring the resistance between one of the terminals 764 and 766 of the first electrode 722 and the second electrode 724 one can find the position where the first and second electrodes are in contact and thus where the force is acting on the sensor. More generally, one can measure any quantity indicative of the resistance between one of the terminals 764 and 766 and the second electrode 724 to obtain that information. In the input device represented schematically in Fig. 8, this is achieved in that voltage source 743 of the control circuit 730 applies a DC potential difference between the terminals 764 and 766 of the first electrode 722. Voltage measurement circuit 746 then measures the voltage on the second electrode, which depends on the location of the contact point between the electrodes 722, 724 and 725.

The input device 710 can also operate in "capacitive" detection mode. The alternating voltage source 750 of the control circuit 730 then applies an oscillating potential difference between the terminals 764 and 766 of the first electrode 722. The resulting oscillating voltage is measured at voltage measurement circuit 746 and indicates the location of capacitive coupling between the first and second electrodes 722 and 725. An equivalent circuit diagram representing this situation is given in Fig. 9. Capacitive coupling between the first and second electrodes 722 and 724 is illustrated as impedance Z_{z}. The connection point 757 of impedance Z_{z} to the first electrode corresponds to the point, where capacitive coupling is highest, e.g. due to the proximity of a user's hand or finger. Because of the very high impedance of the voltage measurement circuit 746, the voltage U₀ detected by the voltage measurement circuit be approximated as U₀ ≈ U_{applied}-Z_{x'}/(Zₓ+Z_{x'}), where U_{applied} is the voltage applied by the alternating voltage source 750. As the total impedance Zₓ+Zₓ, of the first electrode is known, this expression immediately yields Zₓ (and thus the position of capacitive coupling) as a function of the measured voltage U₀.

The control circuit 730 comprises a switching unit 740 for switching between capacitive detection mode and resistive detection mode. In Fig. 8, the voltage measurement circuit 746 is shown being common to the two modes of operation. The control circuit 730 might, however, comprise separate voltage measurement circuit dedicated to a respective mode of operation of the circuit.

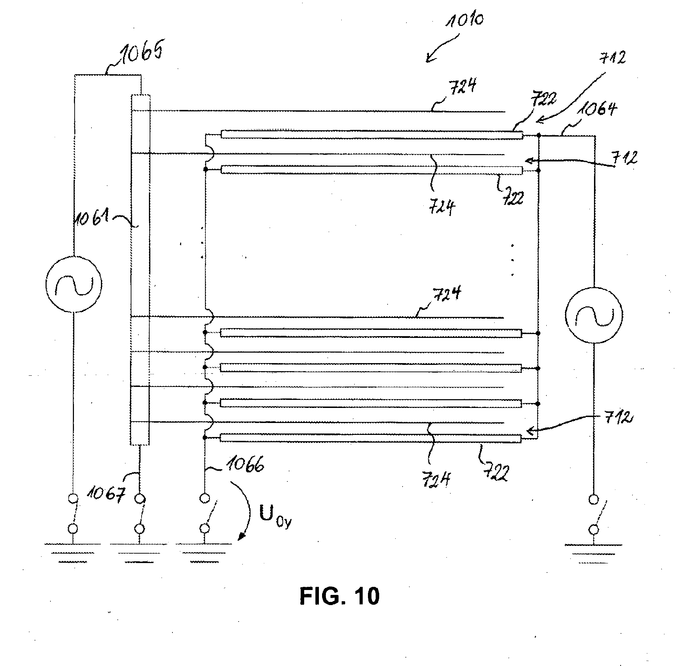

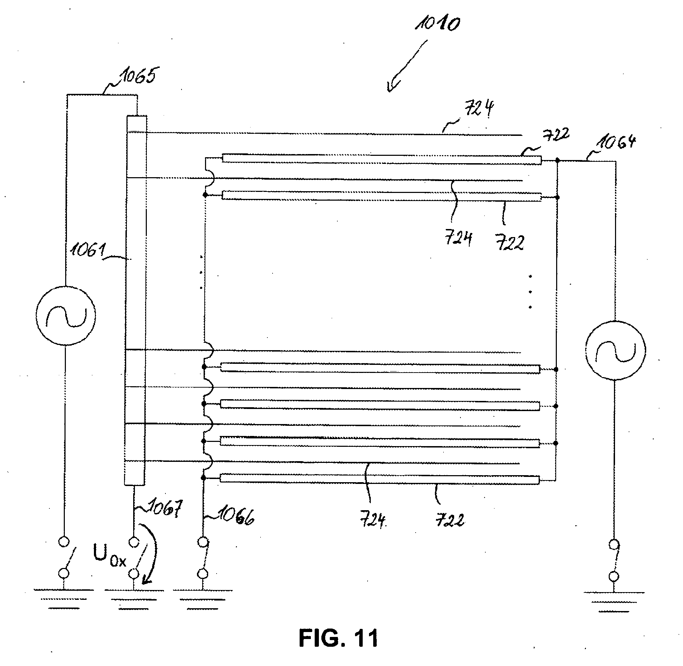

Figs. 10 and 11 schematically illustrate an input device 1010 comprising a plurality of position sensors 712 arranged in parallel. Input device 1010 detects the position of a compressive force or capacitive coupling in two dimensions. The first electrodes 722 of the position sensors 712 are connected between two common terminals 1064 and 1066. The second electrodes 724 are resistively interconnected in series by means of a resistive strip 1061 between terminals 1065 and 1067.

Measuring the y-position of a compressive force or capacitive coupling is illustrated in Fig. 10. A voltage is applied between the terminals 1065 and 1067 and the resulting voltage U_{0y} is measured at terminal 1066 (or at terminal 1064). The applied voltage is preferable a DC voltage in the case of the resistive measurement (for finding the y-position of the compressive force) and an AC voltage in case of the capacitive measurement (for finding the y-position of capacitive coupling). Measuring the x-position of a compressive force or capacitive coupling is illustrated in Fig. 11. A voltage is applied between the terminals 1064 and 1066 and the resulting voltage U₀ₓ is measured at terminal 1067 (or 1065). The applied voltage is preferable a DC voltage in the case of the resistive measurement (for finding the x-position of the compressive force) and an AC voltage in case of the capacitive measurement (for finding the x-position of capacitive coupling).

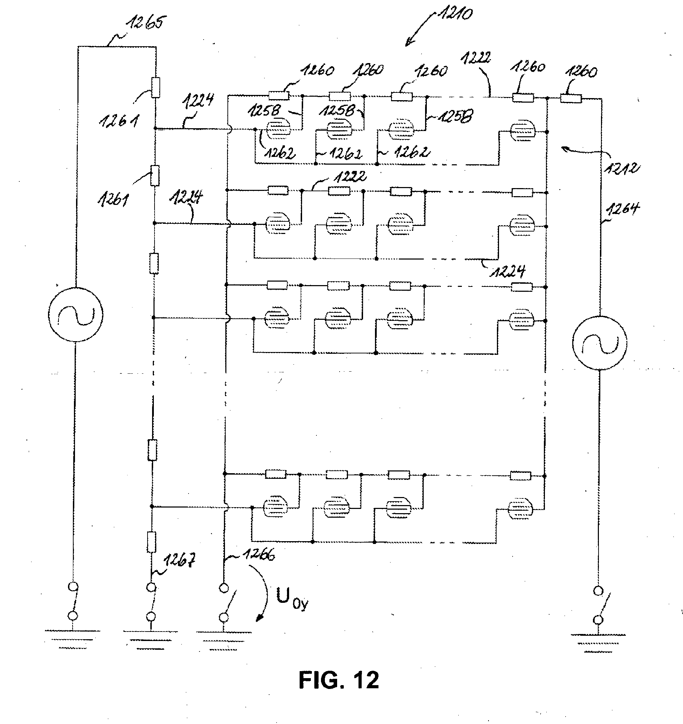

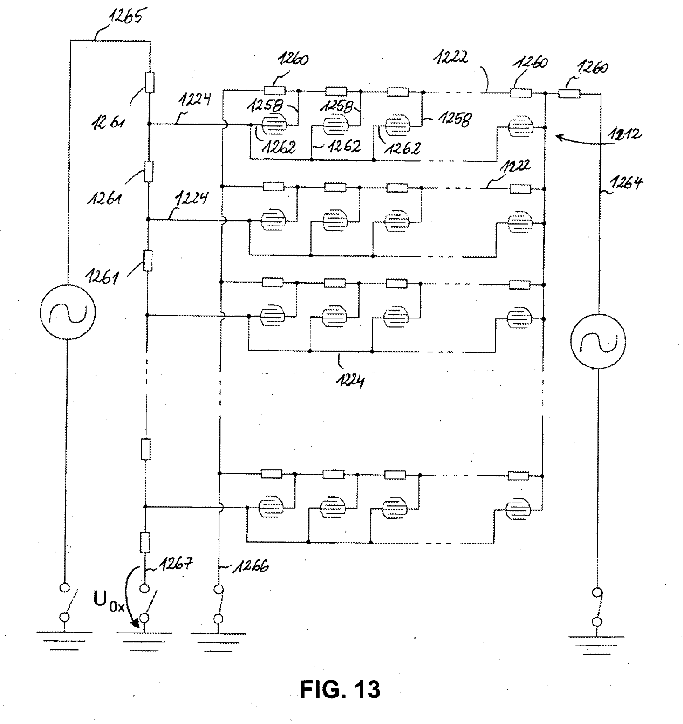

Figs. 12 and 13 illustrate a variant of the input device represented in Figs. 10 and 11. In input device 1210, the layout of the position sensors 712 differs from the layout previously discussed. The first electrodes 1222 comprise respectively a series of first conductors 1258 that are resistively interconnected. Unlike in the previous embodiments, the resistive interconnection is not provided through a continuous resistive strip but through discrete resistors 1260. The second electrodes comprise respectively a series of second conductors 1262 that are conductively interconnected. The first and second conductors protrude into the active zones of the position sensor and form therein interdigitating configurations. The first electrodes 1222 are connected between two common terminals 1264 and 1266. The second electrodes 1224 are resistively interconnected in series between terminals 1265 and 1267 by means of discrete resistors 1261.

Measuring the y-position of a compressive force or capacitive coupling is illustrated in Fig. 12. A voltage is applied between the terminals 1265 and 1267 and the resulting voltage U_{0y} is measured at terminal 1266 (or at terminal 1264). The applied voltage is preferable a DC voltage in the case of the resistive measurement (for finding the y-position of the compressive force) and an AC voltage in case of the capacitive measurement (for finding the y-position of capacitive coupling). Measuring the x-position of a compressive force or capacitive coupling is illustrated in Fig. 13. A voltage is applied between the terminals 1264 and 1266 and the resulting voltage U₀ₓ is measured at terminal 1267 (or 1265). The applied voltage is preferable a DC voltage in the case of the resistive measurement (for finding the x-position of the compressive force) and an AC voltage in case of the capacitive measurement (for finding the x-position of capacitive coupling).

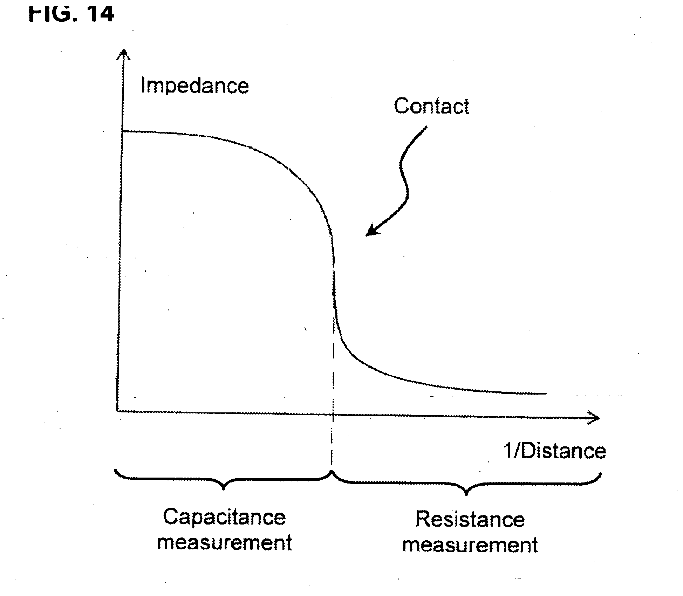

Fig. 14 schematically illustrates the impedance between the first electrode and ground as a function of the distance of an actuating member (e.g. the user's finger, hand or any other body part) to the input device. It is assumed, for the purpose of this explanation, that the first electrode is driven with a voltage at a fixed frequency. In Fig. 14, the distance decreases from left to right along the horizontal axis. If the actuating member is far away from the device, its impedance is maximum. As the actuating member approaches (without getting in contact with the device at this moment), the capacitance between the electrode and ground increases, so that the impedance decreases. As the actuating member gets even closer, it eventually presses onto the device, whereby the first and second electrodes are brought into contact. The capacitance remains now substantially constant but the resistance between the first and second electrodes now decreases with increasing pressure on the sensor. Consequently, the impedance decreases towards a minimum value. It should be noted that the device is advantageously switched from capacitance detection mode (second mode of operation) to resistance detection mode (first mode of operation) about when the actuating member comes into contact with the carrier film.

Fig. 15 shows a data input device 10' according to the second main aspect of the invention, comprising a capacitive proximity and pressure sensor 12' of film-type construction. The capacitive proximity and pressure sensor 12' comprises first and second carrier layers in the form of the first and second carrier films 16', 18', made of substantially flexible, electrically insulating material, such as e.g. PET, PEN, PI or the like. A spacer 20' is sandwiched between the first and second carrier films 16', 18' so as to keep them apart from one another. The spacer 20' is also be made of a substantially flexible, electrically insulating material, e.g. a double-sided adhesive. The spacer 20' is provided with an opening 14' therein, which delimits an active zone of the pressure sensor 10'. In the active zone 14', the first carrier foil 16' carries a first capacitor electrode 22' on the side directed towards the second carrier film 18', while the second carrier foil 18' carries a second capacitor electrode 24' on the side directed towards the first carrier film 16'. The first and second capacitor electrodes 22', 24' are formed from conductive material (e.g. silver ink) applied directly on the first and second carrier films 16', 18', respectively. The second capacitor electrode has formed thereon a layer 26' of electrically insulating material (dielectric, e.g. PET, PEN, PI, etc.).

The right-hand side of Fig. 15 shows a control circuit 28' connected to the first and second capacitor electrodes 22', 24' by leads 30', 32'. The control circuit 28' comprises a microprocessor, an application-specific integrated circuit (ASIC) or a programmable chip, configured so as to operate in at least a first and a second mode of operation. The control circuit determines, while in the second mode of operation, a quantity indicative of a capacitance between the first capacitor electrode and ground and, while in the first mode of operation, a quantity indicative of a capacitance between the first capacitor electrode and the second capacitor electrode.

The second mode of operation is associated to sensing the proximity of an object to be sensed, e.g. of a user's finger 34'. In the second mode of operation the control circuit keeps the first and second electrodes essentially at the same electric potential so that the electric field substantially cancels between the first and second electrodes. The second electrode 24' thus acts as a driven shield for the first electrode 22' and the sensitivity of the latter is directed away from the second electrode 24'. If an oscillating voltage is applied to the first capacitor electrode an oscillating electric field to ground is built up. The object to be sensed modifies the capacitance between the first capacitor electrode and ground, which is sensed by the control circuit 28'. It should be noted that in the second mode of operation detecting the proximity of the object to be does not require the object touching or being in contact with the proximity and pressure sensor 12'.

The first mode of operation is associated with sensing pressure exerted on the sensor by some kind of actuator, such as e.g. the user's finger or stylus. In the first mode of operation, the control circuit essentially determines the capacitance of the capacitor formed by the first and the second capacitor electrodes 22', 24'. It is well known that the capacitance of a capacitor depends upon the distance between its electrodes. In the illustrated case, the distance between the first and second capacitor electrodes decreases with increasing pressure exerted upon the pressure sensor by the user. As a consequence, the capacitance between the capacitor electrodes increases, which is detected by the control circuit 28'.

Fig. 16 shows a variant of the proximity and pressure sensor of Fig. 15. The construction is the same, except that the first capacitor electrode 22', like the second capacitor electrode 24', has formed thereon a layer 26' of electrically insulating material. Those skilled will appreciate that patterning one of the electrically insulating layers 26' allows tailoring the response of the proximity and pressure sensor in the first mode of operation. As long as the electrically insulating layers are spaced from one another (i.e. for low pressures exerted by the user) the pattern has no significant influence on sensor response. However, as the pressure increases the electrically insulating layers come into contact and a contact surface forms. A patterned insulating layer results in that the minimum distance between the first and second electrodes is varying on the contact surface. Accordingly, the capacitance increase is different from the case where the insulating layers are uniform. Examples of patterned insulating layers are shown in Fig. 17.

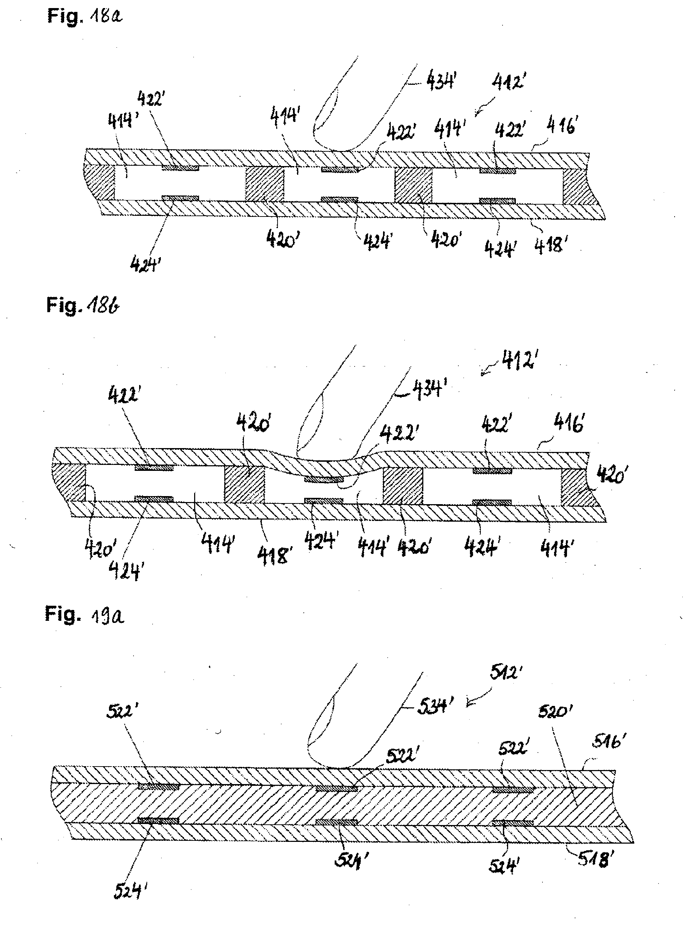

In Figs. 18a-18b, elements similar to elements of Fig. 15 have been attributed the same reference numeral as the corresponding element of Figs. 15 and 16, preceded by the prefix "4".

Figs. 18a and 18b show a cross section of a touchpad 412' having keypad functionality. The touchpad 412' comprises a laminated structure of a first carrier film 416', a second carrier film 418' and a spacer 420', sandwiched between the first and second carrier films so as to keep them spaced apart. The spacer 420' has a matrix-like arrangement of openings 414' therein, which define keys of the touchpad 412'. To each key is associated a pair of a first capacitor electrode 422' and a second capacitor electrode 424' arranged on the first and second carrier films 416', 418', respectively. Each first capacitor electrode 422' is arranged opposite its second-capacitor-electrode counterpart 424', with respect to the associated opening 414' of the spacer 420'. The touchpad 412' further comprises a control circuit (not shown, for the sake of clarity of the drawings), which determines, in a second mode of operation, a quantity indicative of capacitance between individual ones of the first capacitor electrodes 422' and ground and, in a first mode of operation, a quantity indicative of a capacitance between individual ones of the first capacitor electrodes 422' and the associated ones of the second capacitor electrodes 424'.

In Fig. 18a, a user's finger 434' lightly touches the first carrier film 416'. The force exerted is not sufficient to cause significant bending of the first carrier film 416' in the region of a key. The position of the user's finger 434' is detected by determining, for each one of the first capacitor electrodes 422', the quantity indicative of capacitive coupling between this electrode 422' and ground. The position may e.g. be computed as the centroid of the positions of the first capacitor electrodes 422', weighed with the corresponding quantity indicative of capacitance. The second mode of operation is suitable, for instance, when the user controls a cursor (e.g. on the display of an appliance) with the touchpad 412'.

In Fig. 18b, the user presses down the first carrier film 416', so that it bends into an opening 414' of the spacer 420' and the distance between the corresponding first and second capacitor electrodes 422', 424' decreases. This causes the capacitance between these capacitor electrodes to go up, which can be detected in the first mode of operation of the touchpad 412'. The first mode of operation is, therefore, associated to actuation of a key of the touchpad 412', e.g. by a user's finger 434' or a stylus.

In operation, the first and second modes of operation are carried out in alternance, i.e. the touchpad 412' is switched, more or less periodically, from the second mode of operation to the first mode and inversely. It should be noted that, in the first mode of operation, the touchpad does not need to determine the quantity indicative of capacitance for each key. Indeed, it is considered advantageous if the latter is determined only with respect to that key or those keys in the neighborhood of which the position of the user's finger 434' has been detected when the touchpad 412' operated in the second mode of operation.

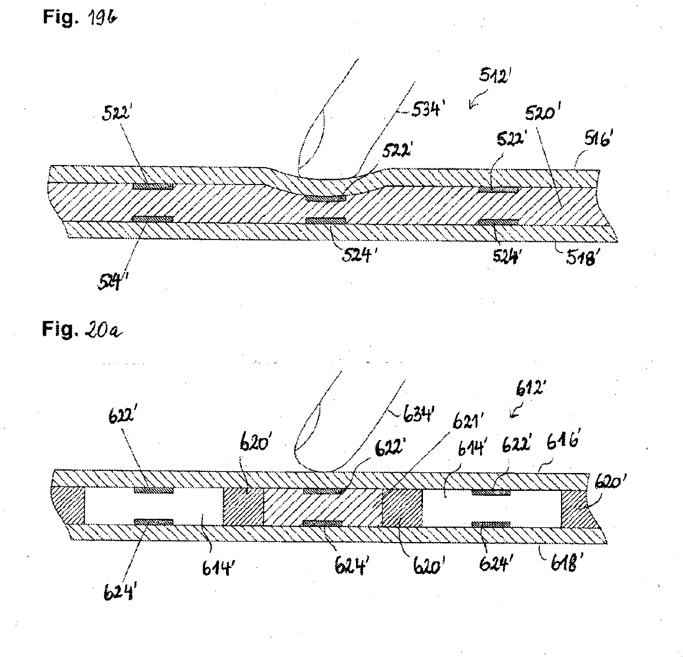

Figs. 19a and 19b show a cross section of an alternative touchpad 512' having keypad functionality. The touchpad 512' comprises a first carrier film 516', a second carrier film 518' and a spacer 521', sandwiched between the first and second carrier films 516', 518' so as to keep them spaced apart. The spacer 521' is made of an electrically insulating, compressible foam material, e.g. polyurethane foam or the like. The first and second carried films 516', 518' have capacitor electrodes 522', 524' applied on the surfaces that face the spacer 521'. Each first capacitor electrode 522' is arranged on the first carrier film opposite a second capacitor electrode 524' on the second carrier film, with respect to the spacer 521'. Each pair of opposite first and second capacitor electrodes defines a key of the touchpad 512'. The latter further comprises a control circuit (not shown), which determines, in a second mode of operation, a quantity indicative of capacitance between individual ones of the first capacitor electrodes 522' and ground and, in a first mode of operation, a quantity indicative of a capacitance between individual ones of the first capacitor electrodes 522' and the associated ones of the second capacitor electrodes 524'.

In Fig. 19a, a user's finger 534' lightly touches the first carrier film 516'. The force exerted is not sufficient to cause significant bending of the first carrier film 516' in the region of a key. The position of the user's finger 534' is detected by determining, for each one of the first capacitor electrodes 522', the quantity indicative of capacitive coupling between this electrode 522' and ground. As in the previous example, the position may e.g. be computed as the centroid of the positions of the first capacitor electrodes 522', weighed with the corresponding quantity indicative of capacitance. The second mode of operation is suitable, for instance, when the user controls a cursor (e.g. on the display of an appliance) with the touchpad 512'.

In Fig. 19b, the user presses on the first carrier film 516', so that the underlying spacer 521' is compressed, whereby the distance between a pair of first and second capacitor electrodes 522', 524' decreases. This causes the capacitance between these capacitor electrodes to go up, which can be detected in the first mode of operation of the touchpad 512'. The first mode of operation is, therefore, associated to actuation of a key of the touchpad 512', e.g. by a user's finger 534' or a stylus.

Operation of the touchpad 512' is similar to the previous example: the first and second modes of operation are carried out in alternance, i.e. the touchpad 512' is switched, more or less periodically, from the second mode of operation to the first mode and inversely. In the first mode of operation, it is considered advantageous if the quantity indicative of capacitance between a first and a second capacitor electrode 522', 524' is determined only with respect to that key or those keys in the neighborhood of which the position of the user's finger 534' has been detected when the touchpad 512' operated in the second mode of operation.

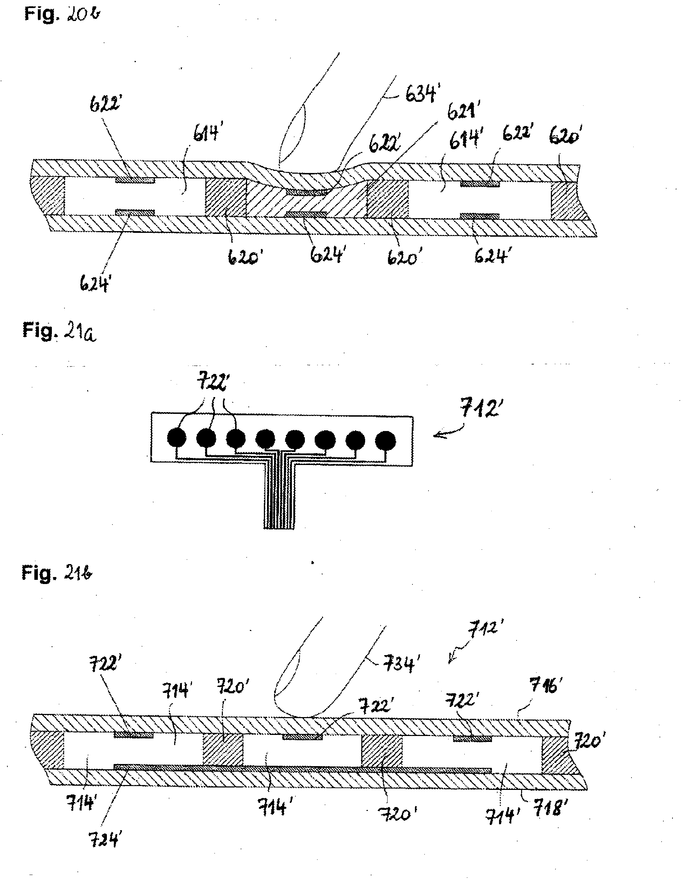

Figs. 20a and 20b illustrate that it is also possible to combine the embodiments of the preceding examples within a single touchpad. The touchpad 612' comprises a first carrier film 616', a second carrier film 618' and a first spacer 620', sandwiched between the first and second carrier films 616', 618' so as to keep them spaced apart. The spacer 620' has a matrix-like arrangement of openings 614' therein, which define keys of the touchpad 612'. To each key is associated a pair of a first capacitor electrode 622' and a second capacitor electrode 624' arranged on the first and second carrier films 616', 618', respectively. Each first capacitor electrode 622' is arranged opposite its second-capacitor-electrode counterpart 624', with respect to the associated opening 614' of the spacer 620'. Some of the openings (middle keys in Figs. 20a and 20b) in spacer 620' are filled with electrically insulating, compressible foam material 621', e.g. polyurethane foam or the like. The spacer 620' is made, in this example, from a flexible material, which has substantially lower compressibility than the foam material 621'. The haptic properties of keys with foam material 621' differ from those without the foam material. Similarly, their capacitance as a function of pressure behaves differently. Nevertheless, operation of touchpad 621' is analogous to operation of touchpads 412' and 512'.

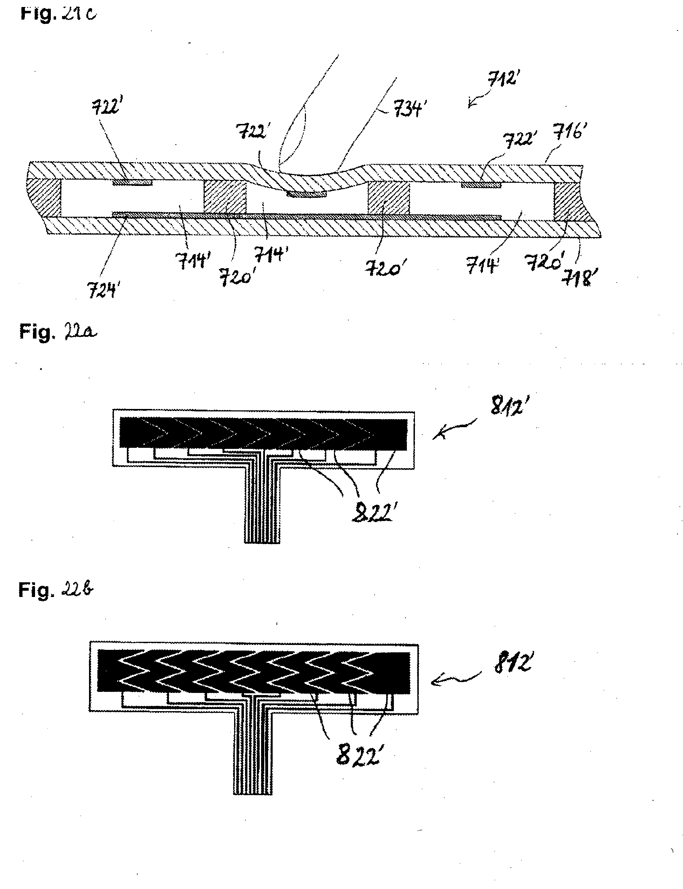

Figs. 21a-21c show a touchpad 712' with keypad functionality, in which the keys are arranged along a straight line (a curve would also be feasible). Fig. 21 a shows the layout of the keys, Figs. 21b and 21c show cross-sectional views of the touchpad 712'. The touchpad 712' comprises a laminated structure of a first carrier film 716', a second carrier film 718' and a spacer 720', sandwiched between the first and second carrier films so as to keep them spaced apart. The spacer 720' has openings 714' therein, which are arranged along a line and which define the keys of the touchpad 712'. To each key is associated a first capacitor electrode 722' arranged on the first carrier film 716'. A common second capacitor electrode 724' extends over all the keys of the touchpad 712'. The touchpad 712' further comprises a control circuit (not shown), which determines, in a second mode of operation, a quantity indicative of capacitance between individual ones of the first capacitor electrodes 722' and ground and, in a first mode of operation, a quantity indicative of a capacitance between individual ones of the first capacitor electrodes 722' and the common second capacitor electrode 724'.

In Fig. 21b, a user's finger 734' lightly touches the first carrier film 716'. The force exerted is not sufficient to cause significant bending of the first carrier film 716' in the region of a key. The position of the user's finger 734' is detected by determining, for each one of the first capacitor electrodes 722', the quantity indicative of capacitive coupling between this electrode 722' and ground. The position may e.g. be computed as the centroid of the positions of the first capacitor electrodes 722', weighed with the corresponding quantity indicative of capacitance. The second mode of operation is suitable, for instance, when the user controls a cursor (e.g. on the display of an appliance) with the touchpad 712'.

In Fig. 21c, the user presses down the first carrier film 716', so that it bends into an opening 714' of the spacer 720' and the distance between the corresponding first electrode722' and the second capacitor electrode 724' decreases. This causes the capacitance between these capacitor electrodes to go up, which can be detected in the first mode of operation of the touchpad 712'. The first mode of operation is, therefore, associated to actuation of a key of the touchpad 712', e.g. by a user's finger 734' or a stylus.

In operation, the first and second modes of operation are carried out in alternance, i.e. the touchpad 712' is switched, more or less periodically, from the second mode of operation to the first mode and inversely. It should be noted that, in the first mode of operation, the touchpad does not need to determine the quantity indicative of capacitance for each key. Indeed, it is considered advantageous if the latter is determined only with respect to that key or those keys in the neighborhood of which the position of the user's finger 734' has been detected when the touchpad 712' operated in the second mode of operation.

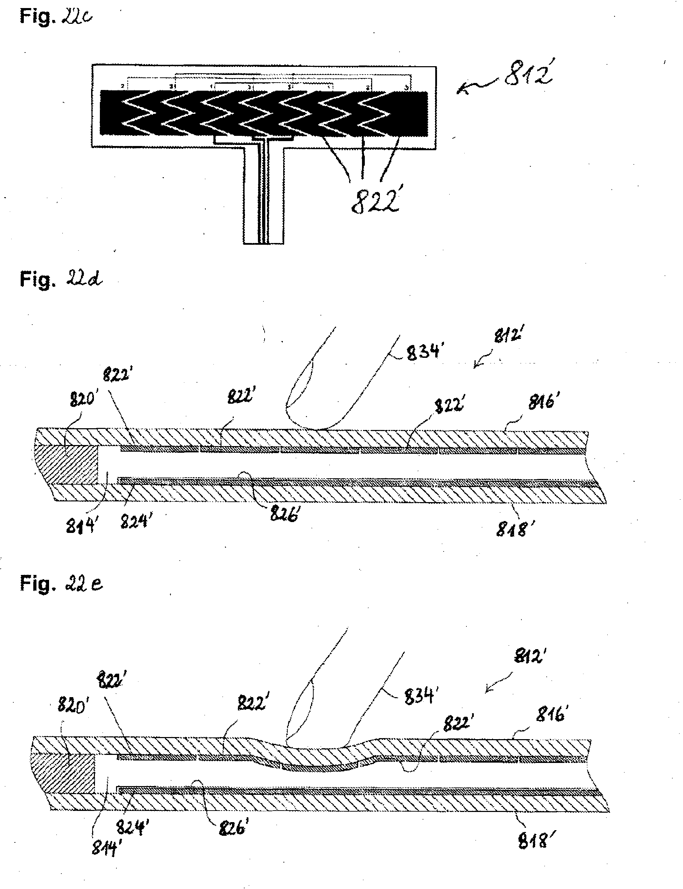

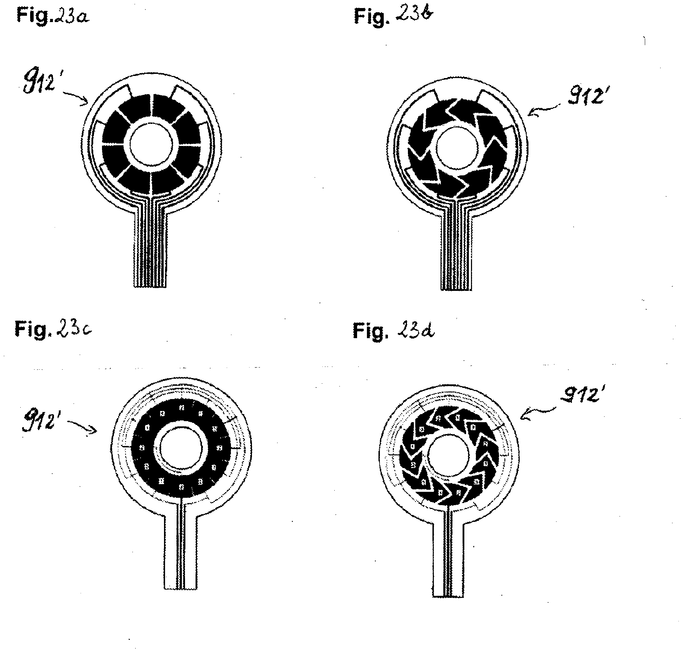

Figs. 22a-22c show possible layouts of a slider 812', Figs. 22d and 22e show cross-sectional views thereof. The slider 812' comprises a laminated structure of a first carrier film 816', a second carrier film 818' and a spacer 820', sandwiched between the first and second carrier films so as to keep them spaced apart. The spacer 820' has an opening 814' therein, which extends, in this case, along a straight line (a curvilinear course is possible, see Figs. 23a-23d). The opening 814' defines the active zone of the slider 812'. The first carrier film 816' has first capacitor electrodes arranged thereon in the active zone, the second carrier film has a common second capacitor electrode 824' applied thereon in the active zone. The first capacitor electrodes 822' are arranged in facing relationship to the second capacitor electrode 824'. The second capacitor electrode has a thin dielectric layer 826' arranged thereon, which prevents short-circuits between the first capacitor electrodes 822' and the second capacitor electrode 824', if they are brought closer to one another by a compressive force acting on the slider 812'.

In Fig. 22d, a user's finger 834' lightly touches the first carrier film 816'. The force exerted is not sufficient to cause significant bending of the first carrier film 816' in the region of the active zone. In Fig. 22e, however, the user presses down the first carrier film 816', so that it locally bends into the opening 814' of the spacer 820' and the distance between the first electrodes 822' and the second capacitor electrode 824' decreases at the point where the force is applied.

In the sliders of Figs. 22a and 22b, the first capacitor electrodes 822' are separately connected to a control circuit (not shown). Accordingly, these sliders are able to detect the position of the user's finger 834' (in the first and the second mode of operation). In the second mode of operation, the control circuit determines, for each one of the first capacitor electrodes 822', the quantity indicative of capacitive coupling between this electrode 822' and ground. The said position may e.g. be computed as the centroid of the positions of the first capacitor electrodes 822', weighed with the corresponding quantity indicative of capacitance. In the first mode of operation, a quantity indicative of a capacitance between single ones of the first capacitor electrodes 822' and the common second capacitor electrode 824' can be detected. As can be seen, operation of the slider 812' as shown in Figs. 22a and 22b is similar to operation of the keypad 712'.

In the slider of Fig. 22c, the first capacitor electrodes are not separately connected to the control circuit. Instead, there are three groups of first capacitor electrodes 822'. The first capacitor electrodes 822' of each group are conductively interconnected. Along the active zone, a first capacitor electrode of the first group is followed by one of the second group, which is, in turn, followed by one of the third group, after which the succession starts again with a first capacitor electrode of the first group. A slider as shown in Fig. 22c is not capable of detecting (absolute) position of the user's finger 834' or stylus. Nevertheless, such slider can detect movement of the user's finger 834' or stylus (in both modes of operation). In the second mode of operation, when the user's finger 834' moves from the left to the right, the succession of the groups of first capacitor electrodes that have increased capacitive coupling to ground is 2-3-1' (and cyclically continued). When the user's finger 834' moves from the right to the left, the succession of the groups of first capacitor electrodes that have increased capacitive coupling to ground is 3-2-1' (and cyclically continued). In the first mode of operation, the direction of movement can be determined from the succession of the groups of first capacitor electrodes that have increased capacitive coupling to the second capacitor electrode. Of course, in the first mode of operation, the amount of force exerted upon the slider can also be detected. For instance, if the quantity indicative of capacitance exceeds a predetermined threshold, some switching action may be triggered.

Given the reduced number of external connectors, the slider of Fig. 22c is particularly interesting if the absolute position need not be known, e.g. for navigating though list-based menus (scrolling through a list of items displayed and selecting an item to enter a sub-menu or start a certain function). The action of selecting an item from the list can e.g. take place when the user presses on the slider with a force that causes the quantity indicative of capacitance between the first and second capacitor electrodes to exceed the predetermined threshold.

Figs. 23a-23d show circular sliders 912'. The sliders of Figs. 23a and 23b are configured for detecting position (sliders with keypad functionality); those of Figs. 23c and 23d are analogous to the linear slider of Fig. 22c.

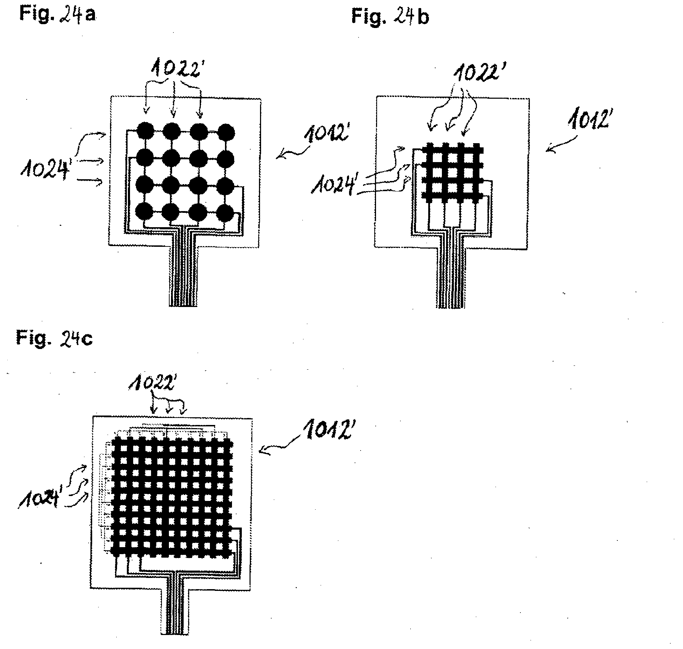

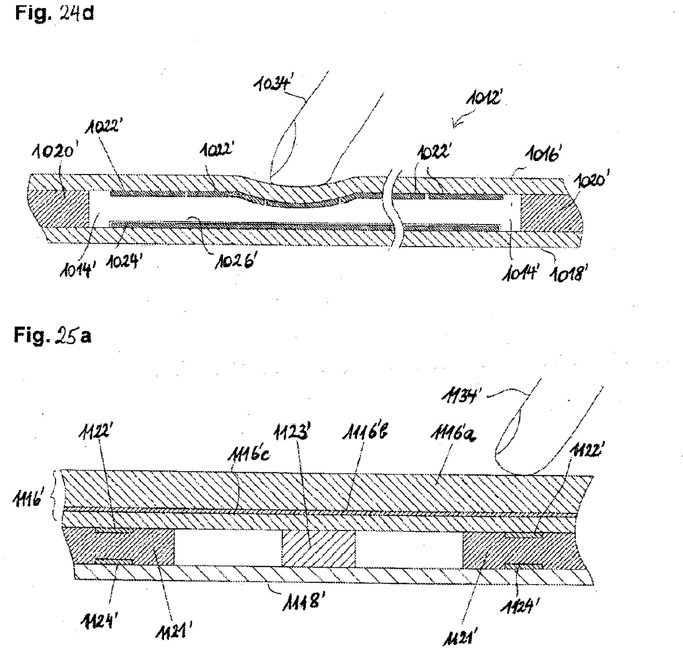

Figs. 24a-24c show schematic top views, Fig. 24d a schematic cross-sectional view of variants of an alternative embodiment of a touchpad 1012'. The touchpad 1012' has a plurality of first elongated capacitor electrodes 1022' applied on the first carrier film 1016' and a plurality of second elongated capacitor electrodes 1024' applied on the second carrier films 1018'. The first capacitor electrodes 1022' are arranged opposite the second capacitor electrodes with respect to an opening 1014' in spacer 1020', which is sandwiched between the carrier films 1016', 1018'. The first capacitor electrodes 1022' extend crosswise to the second capacitor electrodes 1024'. In the shown embodiment, the angle between any one of the first capacitor electrodes and any one of the second capacitor electrodes is 90°; it should, however, be noted that this angle could also be different from 90°, e.g. between 30° and 90°. The second capacitor electrodes 1024' are covered with a thin dielectric layer, which prevent a short-circuit when the first and second capacitor electrodes 1022', 1024' are brought closer together at the location where a compressive force acts on the touchpad 1012'. The touchpad 1012' is connected to control circuit (not shown), which determines, while in the second mode of operation, a quantity indicative of capacitance between individual ones of the first capacitor electrodes 1022' and ground and, while in the first mode of operation, a quantity indicative of a capacitance between individual ones of the first capacitor electrodes 1022' and individual ones of the second capacitor electrodes 1024'.

In the touchpads of Figs. 24a and 24b, the capacitor electrodes 1022' and 1024' are separately connected to a control circuit (not shown). Accordingly, these touchpads are able to detect the position of the user's finger 1034' (with respect to one dimension in the second mode of operation and with respect to two dimensions in the first mode of operation). In the second mode of operation, the control circuit determines, for each one of the first capacitor electrodes 1022', the quantity indicative of capacitive coupling between this electrode 1022' and ground. The position may e.g. be computed as the centroid of the positions of the first capacitor electrodes 1022', weighed with the corresponding quantity indicative of capacitance. It should be noted that in second mode of operation, the position of the user's finger 1034' is detected in the direction perpendicular to the direction along which the first capacitor electrodes extend. In the first mode of operation, the control circuit determines, for each one of the first capacitor electrodes 1022', the quantity indicative of capacitance between this electrode 1022' and each one of the second capacitor electrodes 1024'. The position of the user's finger (the point of application of the force) is obtained from those first and second electrodes, which show maximum capacitive coupling.

In Fig. 24c, the first and the second capacitor electrodes 1022' and 1024' are not separately connected to the control circuit. Instead, there are three groups of first capacitor electrodes 1022' and three groups of second capacitor electrodes 1024'. The capacitor electrodes of each group are conductively interconnected. Along the direction perpendicular to the first capacitor electrodes, a first capacitor electrode of the first group is followed by one of the second group, which is, in turn, followed by one of the third group, after which the succession starts again with a first capacitor electrode of the first group. The second capacitor electrodes are arranged analogously. A touchpad as shown in Fig. 24c is not capable of detecting (absolute) position of the user's finger 1034' or stylus. Nevertheless, such touchpad can detect movement of the user's finger 1034' or stylus. In the second mode of operation, when the user's finger 1034' moves perpendicular to the first capacitor electrodes, the succession of the groups of first capacitor electrodes which have increased capacitive coupling to ground is 2-3-1' (and cyclically continued) or 3-2-1' (and cyclically continued), depending on the direction of the movement. In the first mode of operation, the direction of the movement perpendicular to the first capacitor electrodes can be determined from the succession of the groups of first capacitor electrodes which have increased capacitive coupling to the second capacitor electrodes. Likewise, the direction of the movement perpendicular to the second capacitor electrodes can be determined from the succession of the groups of second capacitor electrodes which have increased capacitive coupling to the first capacitor electrodes. Of course, in the first mode of operation, the amount of force exerted upon the touchpad can also be detected. For instance, if the quantity indicative of capacitance exceeds a predetermined threshold, some switching action may be triggered.

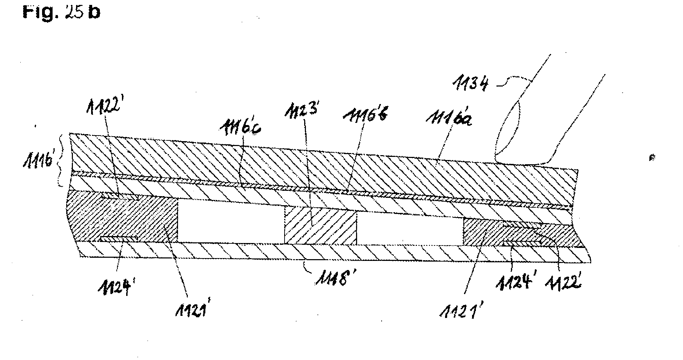

Figs. 25a and 25b show yet another alternative embodiment of an input device including a proximity and pressure sensor 1112'. The capacitive proximity and pressure sensor 1112' comprises a first carrier layer in the form of a substantially rigid cover 1116' and a second carrier layer in the form of a substrate 1118'. The rigid cover 1116' includes a plurality of component layers, such as a protective hard plastic 1116'a, a double-sided adhesive 1116'b and a flexible thermoplastic film 1116'c. A pivot 1123' is sandwiched between the first and second carrier layers 1116', 1118'. The capacitive proximity and pressure sensor 1112' comprises electrode pairs diametrically opposed with respect to the pivot 1123'. Each electrode pair comprises a first capacitor electrode 1122' arranged on the first carrier layer 1116' (on the side directed towards the second carrier layer 1118') and a second capacitor electrode 1124' on the second carrier layer 1118' (on the side directed towards the first carrier layer 1116'). The first and second capacitor electrodes 1122', 1124' are formed from conductive material (e.g. silver ink) applied directly on the first and second carrier layers, respectively. A spacer 1121' made of electrically insulating foam material is arranged between the first and second capacitor electrodes of a pair.

The first and second capacitor electrodes 1122', 1124' are connected to a control circuit (not shown). The control circuit determines, while in the second mode of operation, a quantity indicative of a capacitance between the first capacitor electrodes and ground and, while in the first mode of operation, a quantity indicative of a capacitance between the first capacitor electrode and the second capacitor electrode of each pair.

The second mode of operation is associated to sensing the proximity of an object to be sensed, e.g. of a user's finger 1134'. In the second mode of operation the control circuit keeps the first and second electrodes essentially at the same electric potential so that the electric field substantially cancels between the first and second electrodes. The second electrodes 1124' thus act as driven shields for the respective first electrodes 1122' and the sensitivity of the latter is directed away from the respective second electrode 1124'. If an oscillating voltage is applied to the first capacitor electrode, an oscillating electric field to ground is built up. The object to be sensed modifies the capacitance between the first capacitor electrode and ground, which is sensed by the control circuit 1128'.

The first mode of operation is associated with sensing pressure exerted on the sensor by some kind of actuator, such as e.g. the user's finger 1134' or stylus. In the first mode of operation, the control circuit essentially determines the capacitance of the capacitor formed by the first and the second capacitor electrodes 1122', 1124'. In the embodiment of Figs. 25a and 25b, pressure exerted on the proximity and pressure sensor 1112' by the user causes the first carrier layer to tilt, whereby the first and second capacitor electrodes of a first pair get closer together (right-hand side in Fig. 25b) and those of a second pair are moved away from one another (left-hand side in Fig. 25b). When the user stops pressing on the sensor, the foam spacers 1121' bring the first carrier layer back into the neutral position.

## Claims

1. An input device (10, 210, 710, 1010, 1210, 10') comprising
a film-based pressure sensor (12, 212, 712, 12', 412', 512', 612', 712', 812', 912', 1012', 1112') including a first carrier film (16, 216, 716, 16', 416', 516', 616', 716', 816', 1016', 1116'), a second carrier film (18, 218, 718, 18', 418', 518', 618', 718', 818', 1018', 1118') and a spacer (20, 220, 720, 20', 420', 520', 620', 720', 820', 1020', 1121') arranged between said first and second carrier films (16, 216, 716, 16', 416', 516', 616', 716', 816', 1016', 1116'; 18, 218, 718, 18', 418', 518', 618', 718', 818', 1018', 1118'), an electrode arrangement including at least a first electrode (22, 222, 722, 1222, 22', 422', 522', 622', 722', 822', 1022', 1122') and a second electrode (24, 224, 724, 1224, 24', 424', 524', 624', 724', 824', 1024', 1124'), said electrode arrangement being disposed between said first and second carrier films (16, 216, 716, 16', 416', 516', 616', 716', 816', 1016', 1116'; 18, 218, 718, 18', 418', 518', 618', 718', 818', 1018', 1118') in such a way that, when compressive force acts on the pressure sensor (12, 212, 712, 12', 412', 512', 612', 712', 812', 912', 1012', 1112'), the first and second carrier films (16, 216, 716, 16', 416', 516', 616', 716', 816', 1016', 1116'; 18, 218, 718, 18', 418', 518', 618', 718', 818', 1018', 1118') are brought closer together and a first electric quantity measurable between said first and second electrodes (22, 222, 722, 1222, 22', 422', 522', 622', 722', 822', 1022', 1122'; 24, 224, 724, 1224, 24', 424', 524', 624', 724', 824', 1024', 1124') varies with respect to a situation when no compressive force is applied to the pressure sensor (12, 212, 712, 12', 412', 512', 612', 712', 812', 912', 1012', 1112');
and a control circuit (30, 230, 730, 28'), connected to said first and second electrodes (22, 222, 722, 1222, 22', 422', 522', 622', 722', 822', 1022', 1122'; 24, 224, 724, 1224, 24', 424', 524', 624', 724', 824', 1024'; 1124'), configured so as to operate in a first mode of operation, said control circuit (30, 230, 730, 28') determining, while in said first mode of operation, said first electrical quantity between said first and second electrodes (22, 222, 722, 1222, 22', 422', 522', 622', 722', 822', 1022', 1122'; 24, 224, 724, 1224, 24', 424', 524', 624', 724', 824', 1024', 1124'), said first electrical quantity being indicative of a compressive force acting on said pressure sensor (12, 212, 712, 12', 412', 512', 612', 712', 812', 912', 1012', 1112'); **characterized in that** said control circuit (30, 230, 730, 28') is configured so as to operate at least in a second mode of operation, said control circuit (30, 230, 730, 28') determining, while in said second mode of operation, a second electrical quantity indicative of a capacitance of said first electrode (22, 222, 722, 1222, 22', 422', 522', 622', 722', 822', 1022', 1122').

2. An input device (10, 210, 710) as claimed in claim 1, wherein said spacer (20, 220, 720) has an opening delimiting an active zone (14, 214, 714) of said pressure sensor (12, 212, 712),
wherein said electrode arrangement is arranged in said active zone (14, 214, 714) in such a way that, when compressive force acts on the pressure sensor (12, 212, 712), the first and second carrier films (16, 216, 716; 18, 218, 718) are brought closer together in said active zone (14, 214, 714) and an electrical contact is established between said first and second electrodes (22, 222, 722, 1222; 24, 224, 724, 1224),
and wherein said first electrical quantity is indicative of electrical resistance between said first and second electrodes (22, 222, 722, 1222; 24, 224, 724, 1224).

3. An input device (10) according to claim 2, wherein said first electrode (22) is arranged on said first carrier film (16) and wherein said second electrode (24) is arranged on said second carrier film (18), said first and second electrodes (22; 24) facing one another in said active zone (14),
wherein, optionally, at least one (22) of said first and second electrodes (22; 24) comprises a pressure sensitive layer (28) arranged thereon, in facing relationship with the respective other one (24) of said first and second electrodes (22; 24).

4. An input device (210, 710) according to claim 2, wherein said first and second electrodes (222, 722, 1222; 224, 724, 1224) are arranged on said first carrier film (216, 716), wherein said electrode arrangement comprises a third electrode (225, 725) arranged on said second carrier film (218, 718), said first and second electrodes (222, 722, 1222; 224, 724, 1224) facing said third electrode (225, 725) in said active zone (214, 714) in such a way that, when compressive force acts on the pressure sensor (212, 712), said electrical contact is established between the first and second electrodes (222, 722, 1222; 224, 724, 1224) via said third electrode (225, 725),
wherein, optionally, at least one (225) of said first, second and third electrodes (222, 722, 1222; 224, 724, 1224; 225, 725) comprises a pressure sensitive layer arranged thereon in facing relationship with a respective other one or respective other ones (222, 722, 1222; 224, 724, 1224) of said first, second and third electrodes (222, 722, 1222; 224, 724, 1224; 225, 725).

5. An input device (710) as claimed in claim 4, wherein said first electrode (722, 1222) includes a series of resistively connected first conductors (758, 1258), and wherein said third electrode (725) faces said first electrode (722, 1222) and said second electrode (724, 1224) in said active zone (714) in such a way that, when compressive force acts on the pressure sensor (712, 1212), said electrical contact is established between said second electrode (724, 1224) and one or more of said first conductors (758, 1258), via said third electrode (725),
wherein, optionally, said second electrode (724, 1224) comprises a series of conductively connected second conductors (762, 1262) that are mutually interdigitated with said first conductors (758, 1258).

6. An input device (710) as claimed in claim 5, wherein said first electrical quantity is indicative of a position of said compressive force acting on said pressure sensor (712, 1212)) and wherein said second electrical quantity is indicative of a position of capacitive coupling between said first electrode (722, 1222) and said second electrode (724, 1224).

7. An input device (10, 210, 710) as claimed in any one of claims 1 to 6, wherein said first electrode (22, 222, 722, 1222) is subdivided into at least two electrode portions and wherein said at least two electrode portions are electrically separated at least in said second mode of operation, said quantity indicative of a capacitance of said first electrode (22, 222, 722, 1222) being determined separately for each one of said at least two electrode portions.

8. An input device (10') as claimed in claim 1, wherein said first electrical quantity is indicative of a capacitance between said first electrode (22', 422', 522', 622', 722', 822', 1022', 1122') and said second electrode (24', 424', 524', 624', 724', 824', 1024', 1124').

9. An input device (10') as claimed in claim 8, wherein said spacer (20', 420', 620', 720', 820', 1020') has an opening therein delimiting an active zone (14', 414', 614', 714', 814', 1014') of said pressure sensor (12', 412', 612', 712', 812', 1012'), said first electrode (22', 422', 622', 722', 822', 1022') being arranged, in said active zone (14', 414', 614', 714', 814', 1014'), on said first carrier film (16', 416', 616', 716', 816', 1016'), said second electrode (24', 424', 624', 724', 824', 1024') being arranged, in said active zone (14', 414', 614', 714', 814', 1014'), on said second carrier film (18', 418', 618', 718', 818', 1018'), said first and second electrodes (22', 422', 622', 722', 822', 1022'; 24', 424', 624', 724', 824', 1024') being arranged in facing relationship with one another in such a way that, when compressive force acts on the pressure sensor (12', 412', 612', 712', 812', 1012), the first and second electrodes (22', 422', 622', 722', 822', 1022'; 24', 424', 624', 724', 824', 1024') are brought closer together in said active zone (14', 414', 614', 714', 814', 1014'), wherein said first and/or said second electrode (22', 422', 622', 722', 822', 1022'; 24', 424', 624', 724', 824', 1024') has an insulating layer or insulating pattern (26', 826', 1026') arranged thereon in such a way as to prevent a short circuit between said first and second electrodes (22', 422', 622', 722', 822', 1022'; 24', 424', 624', 724', 824', 1024') when said first and second electrodes (22', 422', 622', 722', 822', 1022'; 24', 424', 624', 724', 824', 1024') are brought closer together.

10. An input device (10') as claimed in claim 8, wherein said first electrode (522', 622', 1122') is arranged on said first carrier film (516', 616', 1116'), wherein said second electrode (524', 624', 1124') is arranged on said second carrier film (518', 618', 1118'), said first and second electrodes (522', 622', 1122'; 524', 624', 1124') being arranged opposite one another with respect to said spacer (520', 621', 1121'), said spacer (520', 621', 1121') being electrically insulating and compressible, in such a way that, when compressive force acts on the pressure sensor (512', 612', 1112'), the first and second electrodes (522', 622', 1122'; 524', 624', 1124') are brought closer together.

11. The input device (10') as claimed in claim 8, wherein said first carrier film (416', 516', 616', 1116') has a plurality of first electrodes (422', 522', 622', 1122') applied thereon, said second carrier film (418', 518', 618', 1122') having a plurality of second electrodes (424', 524', 624', 1124') applied thereon, each one of said plurality of first electrodes (422', 522', 622', 1122') being arranged opposite a respective one of said plurality of second electrodes (424', 524', 624', 1124') with respect to said spacer (420', 520', 620', 121') in such a way that, in response to a compressive force acting on the pressure sensor (412', 512', 612', 1112'), respectively opposite ones of said first and second electrodes (422', 522', 622', 1122'; 424', 524', 624', 1124') are brought closer together;
and wherein said control circuit (28') is configured so as to determine, while in said second mode of operation, a quantity indicative of a capacitance between individual ones of said plurality of first electrodes (422', 522', 622', 1122') and ground;
and, while in said first mode of operation, a quantity indicative of a capacitance between individual ones of said plurality of first electrodes (422', 522', 622', 1122') and the respectively opposite ones of said plurality of second electrodes (424', 524', 624', 1124').

12. An input device (10') as claimed in claim 11, wherein said spacer (420', 620') has a plurality of openings (414', 614') therein, wherein each one of said plurality of first electrodes (422', 622') is arranged opposite a respective one of said plurality of second electrodes (424', 624') with respect to a respective one of said plurality of openings (414', 614') in such a way that, in response to a compressive force acting on the pressure sensor (412', 612'), respectively opposite ones of said first and second electrodes (422', 622'; 424', 624') are brought closer together.

13. The input device (10') as claimed in claim 8, wherein said first carrier film (1016') has a plurality of first electrodes (1022') applied thereon, wherein said second carrier film (1018') has a plurality of second electrodes (1024') applied thereon, said plurality of first electrodes (1022') being arranged opposite said plurality of second electrodes (1024') with respect to said spacer (1020'), said first electrodes (1022') extending transversally to said second electrodes (1024') in such a way that, in response to a compressive force acting locally on the pressure sensor (1012'), opposite ones of said first and second electrodes (1022'; 1024') are brought closer together at the location where said compressive force acts on the pressure sensor (1012'); and wherein said control circuit (28') is configured so as to determine, while in said second mode of operation, a quantity indicative of capacitance between individual ones of said plurality of first electrodes (1022') and ground;
and, while in said first mode of operation, a quantity indicative of a capacitance between individual ones of said plurality of first electrodes (1022') and individual ones of said plurality of second electrodes (1024').

14. An input device (10') as claimed in claim 8, wherein said first carrier film (716', 816') has a plurality of first electrodes (722', 822') applied thereon, said second carrier film (718', 818') has a second electrode (724', 824') applied thereon, said plurality of first electrodes (722', 822') being arranged opposite said second electrode (724', 824') with respect to said spacer (720', 820') in such a way that, in response to a compressive force acting locally on the pressure sensor (712', 812'), individual ones of said first electrodes (722', 822') are brought closer to said second electrode (724', 824') at the location where said compressive force acts on the pressure sensor (712', 812');
and wherein said control circuit (28') is configured so as to determine,
while in said second mode of operation, a quantity indicative of capacitance between individual ones of said first electrodes (722', 822') and ground;
and, while in said first mode of operation, a quantity indicative of a capacitance between said second electrode (724', 824') and individual ones of said first electrodes (722', 822').

15. An input device (10') as claimed in claim 11, 13 or 14, wherein
a) said spacer (420', 620', 720', 820', 1020') has an opening (414', 614', 714', 814', 1014') therein, said plurality of first electrodes (422', 622', 722', 822', 1022') being arranged opposite said second electrode(s) (424', 624', 724', 824', 1024') with respect to said opening (414', 614', 714', 814', 1014') of the spacer (420', 620', 720', 820', 1020'),said plurality of first electrodes (422', 622', 722', 822', 1022') and/or said second electrode(s) (424', 624', 724', 824', 1024') have an insulating layer or insulating pattern (426', 626', 726', 826', 1026') arranged thereon in such a way as to prevent a short circuit between electrodes of said plurality of first electrodes (422', 622', 722', 822', 1022') and said second electrode(s) (424', 624', 724', 824', 1024'), or
b) said spacer (520', 621', 1121') is electrically insulating and compressible, and individual ones of said first electrodes (522', 622', 1122') are brought closer to said second electrode(s) (524', 624', 1124') when said spacer (520', 621', 1121') is compressed in response to a compressive force acting on the pressure sensor (512', 612', 1112').

## Patentansprüche

1. Eingabeeinrichtung (10, 210, 710, 1010, 1210, 10'), aufweisend
einen Drucksensor auf Filmbasis (12, 212, 712, 12', 412', 512', 612', 712', 812', 912', 1012', 1112'), umfassend einen ersten Trägerfilm (16, 216, 716, 16', 416', 516', 616', 716', 816', 1016', 1116'), einen zweiten Trägerfilm (18, 218, 718, 18', 418', 518', 618', 718', 818', 1018', 1118') und einen Abstandhalter (20, 220, 720, 20', 420', 520', 620', 720', 820', 1020', 1121'), der zwischen dem ersten und dem zweiten Trägerfilm (16, 216, 716, 16', 416', 516', 616', 716', 816', 1016', 1116'; 18, 218, 718, 18', 418', 518', 618', 718', 818', 1018', 1118') angeordnet ist, eine Elektrodenanordnung, die mindestens eine erste Elektrode (22, 222, 722, 1222, 22', 422', 522', 622', 722', 822', 1022', 1122') und eine zweite Elektrode (24, 224, 724, 1224, 24', 424', 524', 624', 724', 824', 1024', 1124') aufweist, wobei die Elektrodenanordnung derart zwischen dem ersten und dem zweiten Trägerfilm (16, 216, 716, 16', 416', 516', 616', 716', 816', 1016', 1116'; 18, 218, 718, 18', 418', 518', 618', 718', 818', 1018', 1118') angeordnet ist, dass, wenn eine Druckkraft auf den Drucksensor (12, 212, 712, 12', 412', 512', 612', 712', 812', 912', 1012', 1112') wirkt, der erste und der zweite Trägerfilm (16, 216, 716, 16', 416', 516', 616', 716', 816', 1016', 1116'; 18, 218, 718, 18', 418', 518', 618', 718', 818', 1018', 1118') einander angenähert werden und sich eine erste elektrische Größe, die zwischen der ersten und der zweiten Elektrode (22, 222, 722, 1222, 22', 422', 522', 622', 722', 822', 1022', 1122'; 24, 224, 724, 1224, 24', 424', 524', 624', 724', 824', 1024', 1124') messbar ist, in Bezug auf eine Situation ändert, in der keine Druckkraft an den Drucksensor (12, 212, 712, 12', 412', 512', 612', 712', 812', 912', 1012', 1112') angelegt ist,
und einen Steuerkreis (30, 230, 730, 28'), der mit der ersten und der zweiten Elektrode (22, 222, 722, 1222, 22', 422', 522', 622', 722', 822', 1022', 1122'; 24, 224, 724, 1224, 24', 424', 524', 624', 724', 824', 1024'; 1124') verbunden und dafür konfiguriert ist, in einem ersten Betriebsmodus zu arbeiten, wobei der Steuerkreis (30, 230, 730, 28'), während er im ersten Betriebsmodus arbeitet, die erste elektrische Größe zwischen der ersten und der zweiten Elektrode (22, 222, 722, 1222, 22', 422', 522', 622', 722', 822', 1022', 1122'; 24, 224, 724, 1224, 24', 424', 524', 624', 724', 824', 1024', 1124') bestimmt, wobei die erste elektrische Größe eine auf den Drucksensor (12, 212, 712, 12', 412', 512', 612', 712', 812', 912', 1012', 1112') wirkende Druckkraft anzeigt;
**dadurch gekennzeichnet, dass** der Steuerkreis (30, 230, 730, 28') dafür konfiguriert ist, mindestens in einem zweiten Betriebsmodus zu arbeiten, wobei der Steuerkreis (30, 230, 730, 28'), während er in dem zweiten Betriebsmodus arbeitet, eine zweite elektrische Größe bestimmt, die eine Kapazität der ersten Elektrode (22, 222, 722, 1222, 22', 422', 522', 622', 722', 822', 1022', 1122') anzeigt.

2. Eingabeeinrichtung (10, 210, 710) nach Anspruch 1, wobei der Abstandhalter (20, 220, 720) eine Öffnung aufweist, die einen aktiven Bereich (14, 214, 714) des Drucksensors (12, 212, 712) begrenzt,
wobei die Elektrodenanordnung in dem aktiven Bereich (14, 214, 714) derart angeordnet ist, dass, wenn eine Druckkraft auf den Drucksensor (12, 212, 712) wirkt, der erste und der zweite Trägerfilm (16, 216, 716; 18, 218, 718) in dem aktiven Bereich (14, 214, 714) einander angenähert werden und ein elektrischer Kontakt zwischen der ersten und der zweiten Elektrode (22, 222, 722, 1222; 24, 224, 724, 1224) hergestellt wird,
und wobei die erste elektrische Größe einen elektrischen Widerstand zwischen der ersten und der zweiten Elektrode (22, 222, 722, 1222; 24, 224, 724, 1224) anzeigt.

3. Eingabeeinrichtung (10) nach Anspruch 2, wobei die erste Elektrode (22) auf dem ersten Trägerfilm (16) angeordnet ist und wobei die zweite Elektrode (24) auf dem zweiten Trägerfilm (18) angeordnet ist, wobei die erste und die zweite Elektrode (22; 24) in dem aktiven Bereich (14) zueinander weisen,
wobei gegebenenfalls mindestens eine (22) der ersten und der zweiten Elektrode (22; 24) eine auf dieser angeordnete druckempfindliche Schicht (28) aufweist, und zwar in zueinander weisender Beziehung zu der jeweiligen anderen (24) der ersten und der zweiten Elektrode (22; 24).

4. Eingabeeinrichtung (210, 710) nach Anspruch 2, wobei die erste und die zweite Elektrode (222, 722, 1222; 224, 724, 1224) auf dem ersten Trägerfilm (216, 716) angeordnet sind, wobei die Elektrodenanordnung eine dritte Elektrode (225, 725) aufweist, die auf dem zweiten Trägerfilm (218, 718) angeordnet ist, wobei die erste und die zweite Elektrode (222, 722, 1222; 224, 724, 1224) in dem aktiven Bereich (214, 714) derart zu der dritten Elektrode (225, 725) weisen, dass, wenn eine Druckkraft auf den Drucksensor (212, 712) wirkt, der elektrische Kontakt zwischen der ersten und der zweiten Elektrode (222, 722, 1222; 224, 724, 1224) über die dritte Elektrode (225, 725) hergestellt wird,
wobei gegebenenfalls mindestens eine (225) der ersten, zweiten und dritten Elektrode (222, 722, 1222; 224, 724, 1224; 225, 725) eine druckempfindliche Schicht aufweist, die in zueinander weisender Beziehung mit einer jeweiligen anderen oder mehreren jeweiligen anderen (222, 722, 1222, 224, 724, 1224) der ersten, zweiten und dritten Elektrode (222, 722, 1222, 224, 724, 1224; 225, 725) auf dieser angeordnet ist.

5. Eingabeeinrichtung (710) nach Anspruch 4, wobei die erste Elektrode (722, 1222) eine Reihe von widerstandsmäßig verbundenen ersten Leitern (758, 1258) umfasst, und wobei die dritte Elektrode (725) in dem aktiven Bereich (714) derart zu der ersten Elektrode (722, 1222) und der zweiten Elektrode (724, 1224) weist, dass, wenn eine Druckkraft auf den Drucksensor (712, 1212) wirkt, der elektrische Kontakt zwischen der zweiten Elektrode (724, 1224) und einem oder mehreren der ersten Leiter (758, 1258) über die dritte Elektrode (725) hergestellt wird,
wobei gegebenenfalls die zweite Elektrode (724, 1224) eine Reihe von leitfähig verbundenen zweiten Leitern (762, 1262) aufweist, die zusammen mit den ersten Leitern (758, 1258) verschränkt sind.

6. Eingabeeinrichtung (710) nach Anspruch 5, wobei die erste elektrische Größe eine Position der auf den Drucksensor (712, 1212) wirkenden Druckkraft anzeigt und wobei die zweite elektrische Größe eine Position der kapazitiven Kopplung zwischen der ersten Elektrode (722, 1222) und der zweiten Elektrode (724, 1224) anzeigt.

7. Eingabeeinrichtung (10, 210, 710) nach einem der Ansprüche 1 bis 6, wobei die erste Elektrode (22, 222, 722, 1222) in mindestens zwei Elektrodenabschnitte unterteilt ist und wobei die mindestens zwei Elektrodenabschnitte zumindest in dem zweiten Betriebsmodus elektrisch voneinander getrennt sind, wobei die Größe, die eine Kapazität der ersten Elektrode (22, 222, 722, 1222) anzeigt, separat für jeden der mindestens zwei Elektrodenabschnitte bestimmt wird.

8. Eingabeeinrichtung (10') nach Anspruch 1, wobei die erste elektrische Größe eine Kapazität zwischen der ersten Elektrode (22', 422', 522', 622', 722', 822', 1022', 1122') und der zweiten Elektrode (24', 424', 524', 624', 724', 824', 1024', 1124') anzeigt.

9. Eingabeeinrichtung (10') nach Anspruch 8, wobei der Abstandhalter (20', 420', 620', 720', 820', 1020') eine Öffnung in diesem aufweist, die einen aktiven Bereich (14', 414', 614', 714', 814', 1014') des Drucksensors (12', 412', 612', 712', 812', 1012') begrenzt, wobei die erste Elektrode (22', 422', 622', 722', 822', 1022') in dem aktiven Bereich (14', 414', 614', 714', 814', 1014') auf dem ersten Trägerfilm (16', 416', 616', 716', 816', 1016') angeordnet ist, wobei die zweite Elektrode (24', 424', 624', 724', 824', 1024') in dem aktiven Bereich (14', 414', 614', 714', 814', 1014') auf dem zweiten Trägerfilm (18', 418', 618', 718', 818', 1018') angeordnet ist, wobei die erste und die zweite Elektrode (22', 422', 622', 722', 822', 1022'; 24', 424', 624', 724', 824', 1024') derart in zueinander weisender Beziehung angeordnet sind, dass, wenn eine Druckkraft auf den Drucksensor (12', 412', 612', 712', 812', 1012) wirkt, die erste und die zweite Elektrode (22', 422', 622', 722', 822', 1022'; 24', 424', 624', 724', 824', 1024') in dem aktiven Bereich (14', 414', 614', 714', 814', 1014') einander angenähert werden, wobei die erste und/oder die zweite Elektrode (22', 422', 622', 722', 822', 1022'; 24', 424', 624', 724', 824', 1024') eine Isolierschicht oder ein Isoliermuster (26', 826', 1026') aufweist, die oder das so auf dieser angeordnet ist, dass ein Kurzschluss zwischen der ersten und der zweiten Elektrode (22', 422', 622', 722', 822', 1022'; 24', 424', 624', 724', 824', 1024') verhindert wird, wenn die erste und die zweite Elektrode (22', 422', 622', 722', 822', 1022'; 24', 424', 624', 724', 824', 1024') einander angenähert werden.

10. Eingabeeinrichtung (10') nach Anspruch 8, wobei die erste Elektrode (522', 622', 1122') auf dem ersten Trägerfilm (516', 616', 1116') angeordnet ist, wobei die zweite Elektrode (524', 624', 1124') auf dem zweiten Trägerfilm (518', 618', 1118') angeordnet ist, wobei die erste und die zweite Elektrode (522', 622', 1122'; 524', 624', 1124') in Bezug auf den Abstandhalter (520', 621', 1121') einander gegenüber angeordnet sind, wobei der Abstandhalter (520', 621', 1121') derart elektrisch isolierend und zusammendrückbar ist, dass, wenn eine Druckkraft auf den Drucksensor (512', 612', 1112') wirkt, die erste und die zweite Elektrode (522', 622', 1122'; 524', 624', 1124') einander angenähert werden.

11. Eingabeeinrichtung (10') nach Anspruch 8, wobei der erste Trägerfilm (416', 516', 616', 1116') eine Vielzahl von ersten, darauf aufgebrachten Elektroden (422', 522', 622', 1122') aufweist, wobei der zweite Trägerfilm (418', 518', 618', 1122') eine Vielzahl von zweiten, darauf aufgebrachten Elektroden (424', 524', 624', 1124') aufweist, wobei jede der Vielzahl von ersten Elektroden (422', 522', 622', 1122') gegenüber einerjeweiligen der Vielzahl von zweiten Elektroden (424', 524', 624', 1124') derart in Bezug auf den Abstandhalter (420', 520', 620', 121') angeordnet sind, dass in Abhängigkeit von einer auf den Drucksensor (412', 512', 612', 1112') wirkenden Druckkraft jeweilige gegenüberliegende der ersten und zweiten Elektroden (422', 522', 622', 1122'; 424', 524', 624', 1124') einander angenähert werden;
und wobei der Steuerkreis (28') dafür konfiguriert ist, dass er, wenn er sich in dem zweiten Betriebsmodus befindet, eine Größe bestimmt, die eine Kapazität zwischen einzelnen der Vielzahl von ersten Elektroden (422', 522', 622', 1122') und Masse anzeigt;
und, wenn er sich in dem ersten Betriebsmodus befindet, eine Größe bestimmt, die eine Kapazität zwischen einzelnen der Vielzahl von ersten Elektroden (422', 522', 622', 1122') und den jeweils gegenüberliegenden der Vielzahl von zweiten Elektroden (424', 524', 624', 1124') anzeigt.

12. Eingabeeinrichtung (10') nach Anspruch 11, wobei der Abstandhalter (420', 620') eine Vielzahl von Öffnungen (414', 614') in diesem aufweist, wobei jede der Vielzahl von ersten Elektroden (422', 622') derart gegenüber einer jeweiligen der Vielzahl von zweiten Elektroden (424', 624') in Bezug auf eine jeweilige der Vielzahl von Öffnungen (414', 614') angeordnet ist, dass in Abhängigkeit von einer auf den Drucksensor (412', 612') wirkenden Druckkraft jeweils gegenüberliegende der ersten und zweiten Elektroden (422', 622'; 424', 624') einander angenähert werden.

13. Eingabeeinrichtung (10') nach Anspruch 8, wobei der erste Trägerfilm (1016') eine Vielzahl von ersten, auf diesem aufgebrachten Elektroden (1022') aufweist, wobei der zweite Trägerfilm (1018') eine Vielzahl von zweiten, auf diesem aufgebrachten Elektroden (1024') aufweist, wobei die Vielzahl von ersten Elektroden (1022') gegenüber der Vielzahl von zweiten Elektroden (1024') in Bezug auf den Abstandhalter (1020') angeordnet ist, wobei sich die ersten Elektroden (1022') derart schräg zu den zweiten Elektroden (1024') erstrecken, dass in Abhängigkeit von einer lokal auf den Drucksensor (1012') wirkenden Druckkraft gegenüberliegende der ersten und zweiten Elektroden (1022'; 1024') an der Stelle einander angenähert werden, an der die Druckkraft auf den Drucksensor (1012') wirkt; und wobei der Steuerkreis (28') dafür konfiguriert ist, dass er, wenn er sich in dem zweiten Betriebsmodus befindet, eine Größe bestimmt, die eine Kapazität zwischen einzelnen der Vielzahl von ersten Elektroden (1022') und Masse anzeigt;
und während er sich in dem ersten Betriebsmodus befindet, eine Größe bestimmt, die eine Kapazität zwischen einzelnen der Vielzahl von ersten Elektroden (1022') und einzelnen der Vielzahl von zweiten Elektroden (1024') anzeigt.

14. Eingabeeinrichtung (10') nach Anspruch 8, wobei der erste Trägerfilm (716', 816') eine Vielzahl von ersten, auf diesem aufgebrachten Elektroden (722', 822') aufweist, wobei der zweite Trägerfilm (718', 818') eine zweite, auf diesem aufgebrachte Elektrode (724', 824') aufweist, wobei die Vielzahl von ersten Elektroden (722', 822') derart gegenüber der zweiten Elektrode (724', 824') in Bezug auf den Abstandhalter (720', 820') angeordnet ist, dass in Abhängigkeit von einer lokal auf den Drucksensor (712', 812') wirkenden Druckkraft einzelne der ersten Elektroden (722', 822') an der Stelle der zweiten Elektrode (724', 824') angenähert werden, an der die Druckkraft auf den Drucksensor (712', 812') wirkt;
und wobei der Steuerkreis (28') dafür konfiguriert ist, dass er, wenn er sich in dem zweiten Betriebsmodus befindet, eine Größe bestimmt, die eine Kapazität zwischen einzelnen der ersten Elektroden (722', 822') und Masse anzeigt;
und wenn er sich in dem ersten Betriebsmodus befindet, eine Größe bestimmt, die eine Kapazität zwischen der zweiten Elektrode (724', 824') und einzelnen der ersten Elektroden (722', 822') anzeigt.

15. Eingabeeinrichtung (10') nach Anspruch 11, 13 oder 14, wobei
der Abstandhalter (420', 620', 720', 820', 1020') eine Öffnung (414', 614', 714', 814', 1014') in diesem aufweist, wobei die Vielzahl von ersten Elektroden (422', 622', 722', 822', 1022') gegenüber den (der) zweiten Elektrode(n) (424', 624', 724', 824', 1024') in Bezug auf die Öffnung (414', 614', 714', 814', 1014') des Abstandhalters (420', 620', 720', 820', 1020') angeordnet ist, wobei die Vielzahl von ersten Elektroden (422', 622', 722', 822', 1022') und/oder die zweite(n) Elektrode(n) (424', 624', 724', 824', 1024') eine Isolierschicht oder ein Isoliermuster (426', 626', 726', 826', 1026') aufweist (aufweisen), die oder das derart darauf angeordnet ist, dass ein Kurzschluss zwischen Elektroden der Vielzahl von ersten Elektroden (422', 622', 722', 822', 1022') und der (den) zweiten Elektrode(n) (424', 624', 724', 824', 1024') verhindert wird, oder
der Abstandhalter (520', 621', 1121') elektrisch isolierend und zusammendrückbar ist und einzelne der ersten Elektroden (522', 622', 1122') an die zweite(n) Elektrode(n) (524', 624', 1124') angenähert werden, wenn der Abstandhalter (520', 621', 1121') in Abhängigkeit von einer auf den Drucksensor (512', 612', 1112') wirkenden Druckkraft zusammengedrückt wird.

## Revendications

1. Un dispositif d'entrée (10, 210, 710, 1010, 1210, 10') comprenant un capteur de pression à film (12, 212, 712, 12', 412', 512', 612', 712', 812', 912', 1012', 1112') comprenant un premier film support (16, 216, 716, 16', 416', 516', 616', 716', 816', 1016', 1116'), un deuxième film support (18, 218, 718, 18', 418', 518', 618', 718', 818', 1018', 1118') et un dispositif d'espacement (20, 220, 720, 20', 420', 520', 620', 720', 820', 1020', 1121') agencé entre lesdits premier et deuxième films supports (16, 216, 716, 16', 416', 516', 616', 716', 816', 1016',1116', 18, 218, 718, 18', 418', 518', 618', 718', 818', 1018', 1118'), un agencement d'électrodes comprenant au moins une première électrode (22, 222, 722, 1222, 22', 422', 522', 622', 722', 822', 1022', 1122') et une deuxième électrode (24, 224, 724, 1224, 24', 424', 524', 624', 724', 824', 1024', 1124'), ledit agencement d'électrodes étant disposé entre lesdits premier et deuxième films supports (16, 216, 716, 16', 416', 516', 616', 716', 816', 1016', 1116', 18, 218, 718, 18', 418', 518', 618', 718', 818', 1018', 1118') de telle manière que, lorsqu'une force de compression agit sur le capteur de pression (12, 212, 712, 12', 412', 512', 612', 712', 812', 912', 1012', 1112'), les premier et deuxième films supports (16, 216, 716, 16', 416', 516', 616', 716', 816', 1016', 1116', 18, 218, 718, 18', 418', 518', 618', 718', 818', 1018', 1118') sont rapprochés l'un de l'autre et une première quantité électrique mesurable entre lesdites première et deuxième électrodes (22, 222, 722, 1222, 22', 422', 522', 622', 722', 822', 1022', 1122', 24, 224, 724, 1224, 24', 424', 524', 624', 724', 824', 1024', 1124') varie par rapport à une situation dans laquelle aucune force de compression n'est appliquée au capteur de pression (12, 212, 712, 12', 412', 512', 612', 712', 812', 912', 1012', 1112'),
et un circuit de commande (30, 230, 730, 28'), raccordé auxdites première et deuxième électrodes (22, 222, 722, 1222, 22', 422', 522', 622', 722', 822', 1022', 1122', 24, 224, 724, 1224, 24', 424', 524', 624', 724', 824', 1024', 1124'), configuré de façon à fonctionner dans un premier mode de fonctionnement, ledit circuit de commande (30, 230, 730, 28') déterminant, pendant qu'il se trouve dans ledit premier mode de fonctionnement, ladite première quantité électrique entre lesdites première et deuxième électrodes (22, 222, 722, 1222, 22', 422', 522', 622', 722', 822', 1022', 1122', 24, 224, 724, 1224, 24', 424', 524', 624', 724', 824', 1024', 1124'), ladite première quantité électrique étant indicative d'une force de compression agissant sur ledit capteur de pression (12, 212, 712, 12', 412', 512', 612', 712', 812', 912', 1012', 1112'),
**caractérisé en ce que** ledit circuit de commande (30, 230, 730, 28') est configuré de façon à fonctionner au moins dans un deuxième mode de fonctionnement, ledit circuit de commande (30, 230, 730, 28') déterminant, pendant qu'il se trouve dans ledit deuxième mode de fonctionnement, une deuxième quantité électrique indicative d'une capacité de ladite première électrode (22, 222, 722, 1222, 22', 422', 522', 622', 722', 822', 1022', 1122').

2. Un dispositif d'entrée (10, 210, 710) selon la revendication 1, dans lequel ledit dispositif d'espacement (20, 220, 720) possède une ouverture délimitant une zone active (14, 214, 714) dudit capteur de pression (12, 212, 712),
dans lequel ledit agencement d'électrodes est agencé dans ladite zone active (14, 214, 714) de telle manière que, lorsqu'une force de compression agit sur le capteur de pression (12, 212, 712), les premier et deuxième films supports (16, 216, 716, 18, 218, 718) sont rapprochés l'un de l'autre dans ladite zone active (14, 214, 714) et un contact électrique est établi entre lesdites première et deuxième électrodes (22, 222, 722, 1222, 24, 224, 724, 1224),
et dans lequel ladite première quantité électrique est indicative d'une résistance électrique entre lesdites première et deuxième électrodes (22, 222, 722, 1222, 24, 224, 724, 1224).

3. Un dispositif d'entrée (10) selon la revendication 2, dans lequel ladite première électrode (22) est agencée sur ledit premier film support (16) et dans lequel ladite deuxième électrode (24) est agencée sur ledit deuxième film support (18), lesdites première et deuxième électrodes (22, 24) faisant face l'une à l'autre dans ladite zone active (14),
dans lequel, éventuellement, au moins une (22) desdites première et deuxième électrodes (22, 24) comprend une couche sensible à la pression (28) agencée sur celle-ci, en relation de face à face avec l'autre électrode respective (24) desdites première et deuxième électrodes (22, 24).

4. Un dispositif d'entrée (210, 710) selon la revendication 2, dans lequel lesdites première et deuxième électrodes (222, 722, 1222, 224, 724, 1224) sont agencées sur ledit premier film support (216, 716), dans lequel ledit agencement d'électrodes comprend une troisième électrode (225, 725) agencée sur ledit deuxième film support (218, 718), lesdites première et deuxième électrodes (222, 722, 1222, 224, 724, 1224) faisant face à ladite troisième électrode (225, 725) dans ladite zone active (214, 714) de telle manière que, lorsqu'une force de compression agit sur le capteur de pression (212, 712), ledit contact électrique est établi entre les première et deuxième électrodes (222, 722, 1222, 224, 724, 1224) par l'intermédiaire de ladite troisième électrode (225, 725), dans lequel, éventuellement, au moins une (225) desdites première, deuxième et troisième électrodes (222, 722, 1222, 224, 724, 1224, 225, 725) comprend une couche sensible à la pression agencée sur celle-ci en relation de face à face avec une autre électrode respective ou des autres électrodes respectives (222, 722, 1222, 224, 724, 1224) desdites première, deuxième et troisième électrodes (222, 722, 1222, 224, 724, 1224, 225, 725).

5. Un dispositif d'entrée (710) selon la revendication 4, dans lequel ladite première électrode (722, 1222) comprend une série de premiers conducteurs raccordés de manière conductrice (758, 1258), et dans lequel ladite troisième électrode (725) fait face à ladite première électrode (722, 1222) et à ladite deuxième électrode (724, 1224) dans ladite zone active (714) de telle manière que, lorsqu'une force de compression agit sur le capteur de pression (712, 1212), ledit contact électrique est établi entre ladite deuxième électrode (724, 1224) et un ou plusieurs desdits premiers conducteurs (758, 1258) par l'intermédiaire de ladite troisième électrode (725),
dans lequel, éventuellement, ladite deuxième électrode (724, 1224) comprend une série de deuxièmes conducteurs raccordés de manière conductrice (762, 1262) qui sont mutuellement interdigités avec lesdits premiers conducteurs (758, 1258).

6. Un dispositif d'entrée (710) selon la revendication 5, dans lequel ladite première quantité électrique est indicative d'une position de ladite force de compression agissant sur ledit capteur de pression (712, 1212) et dans lequel ladite deuxième quantité électrique est indicative d'une position d'un couplage capacitif entre ladite première électrode (722, 1222) et ladite deuxième électrode (724, 1224).

7. Un dispositif d'entrée (10, 210, 710) selon l'une quelconque des revendications 1 à 6, dans lequel ladite première électrode (22, 222, 722, 1222) est subdivisée en au moins deux parties d'électrode et dans lequel lesdites au moins deux parties d'électrode sont électriquement séparées au moins dans ledit deuxième mode de fonctionnement, ladite quantité indicative d'une capacité de ladite première électrode (22, 222, 722, 1222) étant déterminée séparément pour chacune desdites au moins deux parties d'électrode.

8. Un dispositif d'entrée (10') selon la revendication 1, dans lequel ladite première quantité électrique est indicative d'une capacité entre ladite première électrode (22', 422', 522', 622', 722', 822', 1022', 1122') et ladite deuxième électrode (24', 424', 524', 624', 724', 824', 1024', 1124').

9. Un dispositif d'entrée (10') selon la revendication 8, dans lequel ledit dispositif d'espacement (20', 420', 620', 720', 820', 1020') possède une ouverture dans celui-ci délimitant une zone active (14', 414', 614', 714', 814', 1014') dudit capteur de pression (12', 412', 612', 712', 812', 1012'), ladite première électrode (22', 422', 622', 722', 822', 1022') étant agencée dans ladite zone active (14', 414', 614', 714', 814', 1014') sur ledit premier film support (16', 416', 616', 716', 816', 1016'), ladite deuxième électrode (24', 424', 624', 724', 824', 1024') étant agencée dans ladite zone active (14', 414', 614', 714', 814', 1014') sur ledit deuxième film support (18', 418', 618', 718', 818', 1018'), lesdites première et deuxième électrodes (22', 422', 622', 722', 822', 1022', 24', 424', 624', 724', 824', 1024') étant agencées en relation de face à face l'une avec l'autre de telle manière que, lorsqu'une force de compression agit sur le capteur de pression (12', 412', 612', 712', 812', 1012), les première et deuxième électrodes (22', 422', 622', 722', 822', 1022', 24', 424', 624', 724', 824', 1024') sont rapprochées l'une de l'autre dans ladite zone active (14', 414', 614', 714', 814', 1014'), dans lequel ladite première et/ou ladite deuxième électrode (22', 422', 622', 722', 822', 1022', 24', 424', 624', 724', 824', 1024') possède une couche d'isolation ou un motif d'isolation (26', 826', 1026') agencé sur celle-ci de façon à empêcher un court-circuit entre lesdites première et deuxième électrodes (22', 422', 622', 722', 822', 1022', 24', 424', 624', 724', 824', 1024') lorsque lesdites première et deuxième électrodes (22', 422', 622', 722', 822', 1022', 24', 424', 624', 724', 824', 1024') sont rapprochées plus étroitement.

10. Un dispositif d'entrée (10') selon la revendication 8, dans lequel ladite première électrode (522', 622', 1122') est agencée sur ledit premier film support (516', 616', 1116'), dans lequel ladite deuxième électrode (524', 624', 1124') est agencée sur ledit deuxième film support (518', 618', 1118'), lesdites première et deuxième électrodes (522', 622', 1122', 524', 624', 1124') étant agencées de manière opposée l'une à l'autre par rapport audit dispositif d'espacement (520', 621', 1121'), ledit dispositif d'espacement (520', 621', 1121') étant électriquement isolant et compressible de telle manière que, lorsqu'une force de compression agit sur le capteur de pression (512', 612', 1112'), les première et deuxième électrodes (522', 622', 1122', 524', 624', 1124') sont rapprochées plus étroitement.

11. Le dispositif d'entrée (10') selon la revendication 8, dans lequel ledit premier film support (416', 516', 616', 1116') possède une pluralité de premières électrodes (422', 522', 622', 1122') appliquées sur celui-ci, ledit deuxième film support (418', 518', 618', 1122') possédant une pluralité de deuxièmes électrodes (424', 524', 624', 1124') appliquées sur celui-ci, chaque électrode de ladite pluralité de premières électrodes (422', 522', 622', 1122') étant agencée à l'opposé d'une électrode respective de ladite pluralité de deuxièmes électrodes (424', 524', 624', 1124') par rapport audit dispositif d'espacement (420', 520', 620', 121') de telle manière que, en réponse à une force de compression agissant sur le capteur de pression (412', 512', 612', 1112'), des électrodes respectivement opposées desdites premières et deuxièmes électrodes (422', 522', 622', 1122', 424', 524', 624', 1124') sont rapprochées les unes des autres,
et dans lequel ledit circuit de commande (28') est configuré de façon à déterminer,
pendant qu'il se trouve dans ledit deuxième mode de fonctionnement, une quantité indicative d'une capacité entre des électrodes individuelles de ladite pluralité de premières électrodes (422', 522', 622', 1122') et la terre,
et, pendant qu'il se trouve dans ledit premier mode de fonctionnement, une quantité indicative d'une capacité entre des électrodes individuelles de ladite pluralité de premières électrodes (422', 522', 622', 1122') et les électrodes respectivement opposées de ladite pluralité de deuxièmes électrodes (424', 524', 624', 1124').

12. Un dispositif d'entrée (10') selon la revendication 11, dans lequel ledit dispositif d'espacement (420', 620') possède une pluralité d'ouvertures (414', 614') dans celui-ci, dans lequel chaque électrode de ladite pluralité de premières électrodes (422', 622') est agencée à l'opposé d'une électrode respective de ladite pluralité de deuxièmes électrodes (424', 624') par rapport à une ouverture respective de ladite pluralité d'ouvertures (414', 614') de telle manière que, en réponse à une force de compression agissant sur le capteur de pression (412', 612'), des électrodes respectivement opposées desdites premières et deuxièmes électrodes (422', 622', 424', 624') sont rapprochées les unes des autres.

13. Le dispositif d'entrée (10') selon la revendication 8, dans lequel ledit premier film support (1016') possède une pluralité de premières électrodes (1022') appliquées sur celui-ci, dans lequel ledit deuxième film support (1018') possède une pluralité de deuxièmes électrodes (1024') appliquées sur celui-ci, ladite pluralité de premières électrodes (1022') étant agencée à l'opposé de ladite pluralité de deuxièmes électrodes (1024') par rapport audit dispositif d'espacement (1020'), lesdites premières électrodes (1022') s'étendant transversalement auxdites deuxièmes électrodes (1024') de telle manière que, en réponse à une force de compression agissant localement sur le capteur de pression (1012'), des électrodes opposées desdites premières et deuxièmes électrodes (1022', 1024') sont rapprochées les unes des autres à l'emplacement où ladite force de compression agit sur le capteur de pression (1012'),
et dans lequel ledit circuit de commande (28') est configuré de façon à déterminer,
pendant qu'il se trouve dans ledit deuxième mode de fonctionnement, une quantité indicative d'une capacité entre des électrodes individuelles de ladite pluralité de premières électrodes (1022') et la terre, et, pendant qu'il se trouve dans ledit premier mode de fonctionnement, une quantité indicative d'une capacité entre des électrodes individuelles de ladite pluralité de premières électrodes (1022') et des électrodes individuelles de ladite pluralité de deuxièmes électrodes (1024').

14. Un dispositif d'entrée (10') selon la revendication 8, dans lequel ledit premier film support (716', 816') possède une pluralité de premières électrodes (722', 822') appliquées sur celui-ci, ledit deuxième film support (718', 818') possède une deuxième électrode (724', 824') appliquée sur celui-ci, ladite pluralité de premières électrodes (722', 822') étant agencée à l'opposé de ladite deuxième électrode (724', 824') par rapport audit dispositif d'espacement (720', 820') de telle manière que, en réponse à une force de compression agissant localement sur le capteur de pression (712', 812'), des électrodes individuelles desdites premières électrodes (722', 822') sont rapprochées les unes des autres de ladite deuxième électrode (724', 824') à l'emplacement où ladite force de compression agit sur le capteur de pression (712', 812'),
et dans lequel ledit circuit de commande (28') est configuré de façon à déterminer,
pendant qu'il se trouve dans ledit deuxième mode de fonctionnement, une quantité indicative d'une capacité entre des électrodes individuelles desdites premières électrodes (722', 822') et la terre, et, pendant qu'il se trouve dans ledit premier mode de fonctionnement, une quantité indicative d'une capacité entre ladite deuxième électrode (724', 824') et des électrodes individuelles desdites premières électrodes (722', 822').

15. Un dispositif d'entrée (10') selon la revendication 11, 13 ou 14, dans lequel
a) ledit dispositif d'espacement (420', 620', 720', 820', 1020') possède une ouverture (414', 614', 714', 814', 1014') dans celui-ci, ladite pluralité de premières électrodes (422', 622', 722', 822', 1022') étant agencée à l'opposé de ladite/desdites deuxième(s) électrode(s) (424', 624', 724', 824', 1024') par rapport à ladite ouverture (414', 614', 714', 814', 1014') du dispositif d'espacement (420', 620', 720', 820', 1020'), ladite pluralité de premières électrodes (422', 622', 722', 822', 1022') et/ou ladite/lesdites deuxième(s) électrode(s) (424', 624', 724', 824', 1024') possèdent une couche d'isolation ou un motif d'isolation (426', 626', 726', 826', 1026') agencé sur celles-ci de façon à empêcher un court-circuit entre des électrodes de ladite pluralité de premières électrodes (422', 622', 722', 822', 1022') et ladite/lesdites deuxième(s) électrode(s) (424', 624', 724', 824', 1024'), ou
b) ledit dispositif d'espacement (520', 621', 1121') est électriquement isolant et compressible, et des électrodes individuelles desdites premières électrodes (522', 622', 1122') sont rapprochées les unes des autres de ladite/lesdites deuxième(s) électrode(s) (524', 624', 1124') lorsque ledit dispositif d'espacement (520', 621', 1121') est comprimé en réponse à une force de compression agissant sur le capteur de pression (512', 612',1112').
